(19) Europäisches Patentamt
European Patent Office
Office européen des brevets

(11) **EP 1 228 564 B1**

(12) **EUROPEAN PATENT SPECIFICATION**

(45) Date of publication and mention
of the grant of the patent:
**09.09.2015 Bulletin 2015/37**

(51) Int Cl.:
*H03H 11/22* (2006.01)    *H04B 1/28* (2006.01)
*H04B 1/40* (2015.01)    *H03L 7/089* (2006.01)
*H03L 7/099* (2006.01)    *H03L 7/197* (2006.01)
*H03H 11/04* (2006.01)

(21) Application number: **00978551.0**

(22) Date of filing: **13.11.2000**

(86) International application number:
**PCT/US2000/031065**

(87) International publication number:
**WO 2001/035529 (17.05.2001 Gazette 2001/20)**

(54) **SINGLE CHIP CMOS TRANSMITTER/RECEIVER AND METHOD OF USING SAME**

EINZELCHIP CMOS SENDER/EMPFÄNGER UND VERFAHREN ZU DEREN VERWENDUNG

EMETTEUR/RECEPTEUR CMOS MONOPUCE ET PROCEDE D'UTILISATION

(84) Designated Contracting States:
**AT BE CH CY DE DK ES FI FR GB GR IE IT LI LU MC NL PT SE TR**
Designated Extension States:
**AL LT LV MK RO SI**

(30) Priority: **12.11.1999 US 164874 P**

(43) Date of publication of application:
**07.08.2002 Bulletin 2002/32**

(73) Proprietor: **GCT Semiconductor, Inc.**
**Santa Clara, CA 95054 (US)**

(72) Inventors:
• **LEE, Kyeongho,**
**309-901 Sam-Sung-San-Ju-Kong APT**
**Kwanak-ku,**
**Seoul (KR)**
• **JEONG, Deog-Kyoon,**
**301-803 School of Elec. Eng.**
**Kwanak-ku,**
**Seoul (KR)**
• **PARK, Joonbae**
**Seo-Cho-Ku,**
**Seoul (KR)**
• **KIM, Wonchan**
**Kwanak-gu,**
**Seoul (KR)**

(74) Representative: **Boden, Keith McMurray et al**
**Fry Heath & Spence LLP**
**The Gables**
**Massetts Road**
**Horley**
**Surrey RH6 7DQ (GB)**

(56) References cited:
**US-A- 5 880 613    US-A- 5 963 855**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**BACKGROUND OF THE INVENTION**

1. **Field of the Invention**

The present invention relates to a communication system, and in particular, to a CMOS radio frequency (RF) communication system.

2. **Background of the Related Art**

Presently, a radio frequency (RF) communications system has a variety of applications including PCS communication and IMT systems. As such, a CMOS chip integration of the system has been pursued to reduce the cost, size and power consumption.

US-A-5963855 discloses a method of extending the RSSI range of a radio transceiver and describes an embodiment having an AGC amplifier.

Generally, the RF communication system is composed of RF front-end block and base-band digital signal processing (DSP) block or baseband modem block. Currently, the base-band DSP block can be implemented with low cost and low power CMOS technology. However, the RF front-end cannot be implemented by CMOS technology because of limitations in speed, bandwidth and noise characteristics, which are bellow the speed, the frequency and noise specifications of popular RF communication systems.

For example, the PCS hand-phone systems operate at a frequency over 2.0 GHz, but current CMOS technology reliably operates only up to approximately 1.0 GHz in terms of speed and noise. Hence, the RF front-end block is implemented using bipolar, bi-CMOS or GaAs technology that has better speed, bandwidth and noise characteristics than CMOS technology but is more expensive and consumes more power.

Currently, two different types of RF architecture called "direct conversion" and super-heterodyne (double conversion) are used for CMOS RF communication systems. Both architectures have advantages and disadvantages in terms of CMOS implementations.

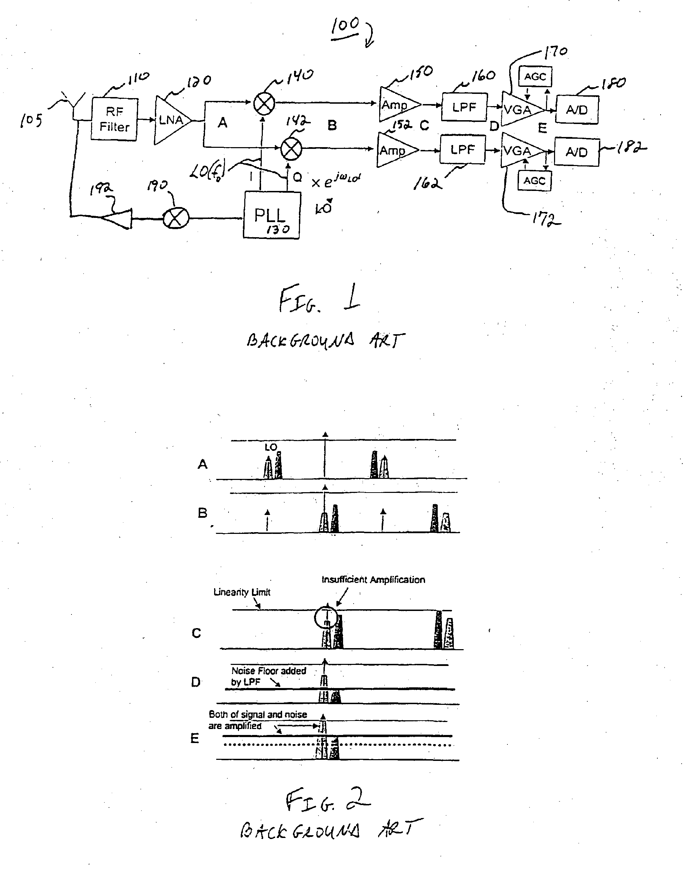

Fig. 1 is a diagram showing a related art direct conversion RF system 100. A related art direct conversion CMOS RF communication system 100 includes an antenna 105, a RF filter 110, a low noise amplifier (LNA) 120, a phase-locked loop (PLL) 130, a first mixer 140, a second mixer 142, first and second amplifiers 150, 152, a first low pass filter (LPF) 160, a second LPF 162, first and second variable gain amplifiers (VGA) 170, 172 each including automatic gain control (AGC) loops, a first analog/digital (A/D) converter 180, a second A/D converter 182, a third mixer 190 and a power amplifier 192.

The antenna 105 receives RF signals. The received RF signal is composed of various RF bands. Selected RF signals are then filtered at the RF filter 110. That is, out-of-band RF signals (e.g., irrelevant RF bands) are removed by the RF filter 110. The filtered in-band RF signals are amplified with a gain at the LNA 120. However, the in-band RF signal is composed of in-band channels and possible image bands, which is shown as A in Figures 1 and 2. The in-band RF signals passing through the LNA 120 are directly demodulated into base band signals by quadrature multiplication at the first and second mixers 140 and 142 because the LO frequency is equal to the carrier frequency. The PLL 130 preferably generates two types of clock signals, I clock signals and Q clock signals using a voltage controlled oscillator (VCO). The I clock signals and the Q clock signals are the same excepting a phase difference, The I signals preferably have a phase difference of 90 degrees from the Q signals. That is, Q signals are phase shifted with respect to quadrature phase shift I signals. The two sets of signals I and Q are preferably used to increase the ability of the RF system to identify or maintain received information regardless of noise and interference. Sending two types of signals having different phases reduces the probability of information loss or change.

As shown at B in Figures 1 and 2, the down converted signal includes the desired channel, adjacent channels and an up-converted signal. The down-converted signal is amplified by amplifiers 150, 152 before passing through corresponding low-pass filters (LPF) 160, 162 to prevent drastic signal-to-noise-ratio (SNR) degradation by noise injection from the LPFs 160, 162, which is shown as C in Figures 1 and 2. The signals from the LPFs 160, 162 are amplified by variable gain amplifiers (VGAs) 170,172, respectively, and become respective signals required for A/D conversion at first and second A/D converters 180, 182. However, the desired channel cannot be amplified to a maximum level allowed by the linearity limit because the adjacent channel can reach the linearity limite before the desired channel is amplified to the required level. Thus, in the related art direct conversion architecture 100, amplification of the entire channel is reduced as the adjacent channel power increases, which also results in SNR degradation. As shown at D in Figures 1 and 2, the LPFs 160, 162 output a large noise floor that is added to the desired channel by the LPFs 160, 162. Accordingly, both the desired channel and the noise floor are amplified when the desired channel is amplified to the required level before the A/D conversion as shown at E in Figures 1 and 2.

The digital signals are then transferred to a base-band discrete-time signal processing (DSP) block (not shown). Channel selection is performed by. changing frequency $f_0$ in at the phase-locked loop (PLL) 130.

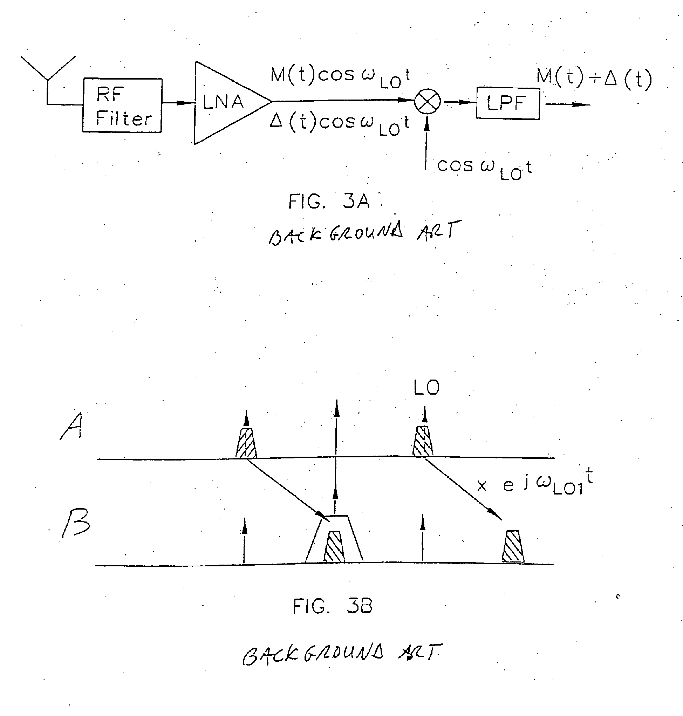

As described above, the related art direct conversion RF system 100 has advantages for CMOS RF integration because of its simplicity. In the related art direct conversion RF system only a single PLL is required. Further, in the related art direct conversion RF system high-quality filters are not required. However, the related art direct conversion architecture has disadvantages that make single chip integration difficult or impossible. As shown in Figure 3A, clock signals cos $\omega_{LO}t$ from a local oscillator (LO) such as the VCO may leak to either the mixer input or to the antenna where radiations can occur because the local oscillator (LO) is at the same frequency as the RF carriers. The unintentionally transmitted clock signals $\Delta(t)$cos $\omega_{LO}t$ can reflect off nearby objects and be "re-received" by the mixer again. The low pass filter outputs a signal M(t) +$\Delta$(t) because of leakages of clock signals. As shown in Figure 3B, self-mixing with the local oscillator results in problems such as time variations or "wandering" DC-offsets at the output of the mixer. The time-varying DC-offset together with inherent circuit offsets significantly reduce the dynamic range of the receiver portion. Further, as discussed above, a related art direct conversion RF system requires a high-frequency, low-phase-noise PLL for channel selection, which is difficult to achieve with an integrated CMOS voltage controlled oscillator (VCO).

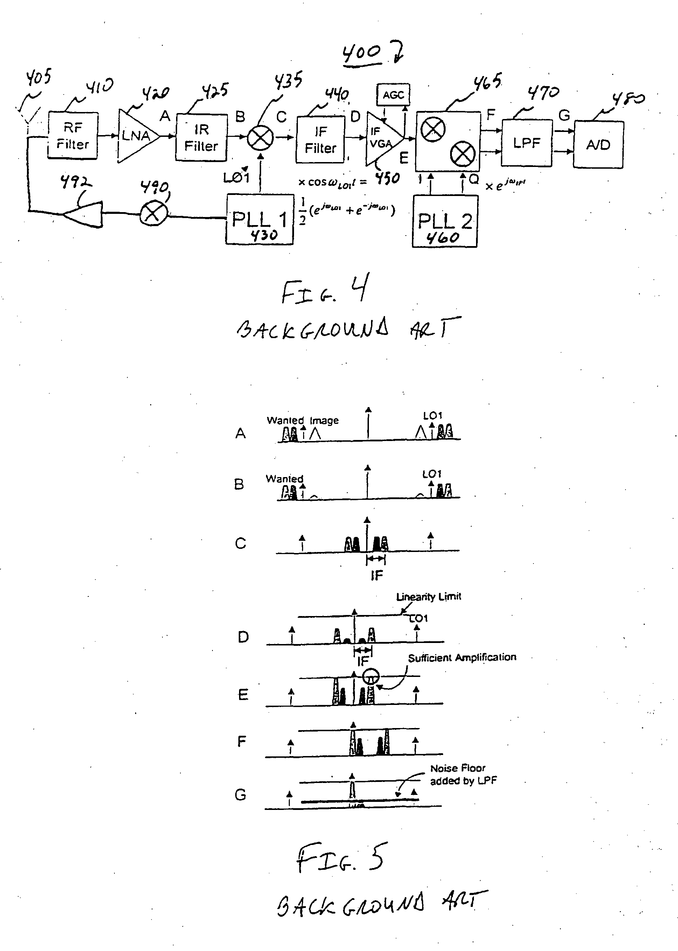

Figure 4 shows a block diagram of a related art RF communication system 400 according to a double conversion architecture that considers all of the potential channels and frequency translates them first from RF to IF and then from IF to baseband using a tunable channel select PLL. As shown in Figure 4, the RF communication system 400 includes antenna 405, a RF filter 410, a LNA 420, IR filter 425, a phase lock loop (PLL) PLL1 430, a first mixer 435, a IF filter 440, IF VGA 450, a PLL2 460, a second mixer 465, a LPF 470, an A/D converter 480, a third mixer 490 and a power amplifier 492.

The mixers 435, 465 are all for demodulation while the mixer 490 is for modulation. The mixer 435 is for a selected RF frequency and the mixer 465 is for an intermediate frequency (IF). The PLL1 430 generates clock signals at a high frequency or the RF frequency, the PLL2 460 generates clock signals having a low frequency or the intermediate frequency (IF).

Transmission data are multiplied with the clock signals having the high frequency from the PLL 430 to have an original transmission data frequency by the mixer 490. The output signals of the mixer 490 are amplified with a gain at the power amplifier 492 and then radiated through the antenna 405 for transmission.

Operations of the related art super-heterodyne receiver will now be described. Initially, an RF signal is received by the antenna 405. The received RF signal includes various RF bands. The RF filter 410 filters out out-of-band RF signals and the LNA 420 amplifies the in-band RF signal composed of in-band signals and possible image bands as shown at A in Figures 4-5. Image bands are filtered out by the image rejection (IR) filter 425 as shown at B in Figures 4-5. Otherwise, the image bands are mixed with the in-band RF signal after a first down conversion by the mixer 435 and PLL1 430 combination. Thus, the in-band RF channels are down converted into an IF frequency by a first down conversion at mixer 435 using a local oscillator signal LO1 as shown at C in Figures 4-5. The PLL1 430 generates the local oscillator signals for I signals of the RF signals and for Q signals of the RF signals.

The band-pass IF filter 440 rejects adjacent channels so that only the desired or dedicated channel has a dominant power level at the IF frequency as shown at D in Figures 4-5. The IF VGA 450 that includes an AGC loop amplifies the dedicated channel at the IF frequency to get an amplitude sufficiently large to overcome a large noise floor of the downstream LPF 470. The AGC loop continuously detects the amplitude of the IF VGA 450 output and controls its VGA gain so that a maximum amplitude allowed by the linearity limit can be obtained. As a result, the dual-conversion receiver can achieve the required SNR by the IF-filtering and amplification as shown at E in Figures 4-5. An adjacent channel is not a bottleneck or problem of IF amplification because of filtering by IF filter 440 before the IF amplification is performed by the IF VGA 450. However, if the adjacent channel is not eliminated before the IF amplification, the dedicated channels cannot be amplified to a maximum value because the adjacent channel can reach the linearity limit before the dedicated channel is amplified to the maximum level.

The amplified RF signal is down-converted again into the baseband by the second down-converting mixer 465 and using a local oscillator signal LO2 from the PLL2 460 as shown at F in Figures 4-5. The low-pass filter 470 filters out the up-converted signal and remaining adjacent channels as shown at G in Figures 4-5, which indicates the noise floor added by the LPF 470. The A/D converter 480 converts the signals into digital data, which is then transferred into a baseband discrete-time signal processing (DSP) block (not shown). All of the channels at the IF stage are frequency-translated directly to baseband frequency by the tunable PLL2 460 for channel selection.

As described above, the related art super-heterodyne RF system 400 has various advantages. The related art double conversion RF system 400 performs the channel tuning using the lower-frequency (i.e., IF) second PLL 460, but not the high-frequency, (i.e., RF) first PLL 430. Consequently, the high-frequency RF PLL 430 can be a fixed-frequency PLL that can be more effectively optimized. Further, since channel tuning is performed with the IF PLL 460, which operates at a lower frequency, the contribution of phase noise into channel selection can be reduced. However, the related art double conversion RF system 400 has various disadvantages to overcome for single chip integration. The related art double conversion RF system 300 uses two PLLs, which are difficult to integrate in a single chip. Further, the frequency of first PLL remains too high to be implemented with CMOS technology, and in particular, with a CMOS VCO. In addition, self-mixing problem still occurs because the second PLL is at the same frequency of the IF desired carrier. The output signals of the second mixer may leak to a substrate or may leak to the second mixer again. The time-varying DC-offset, together with inherent circuit offsets significantly reduces the dynamic range of the receiver portion. In addition, CMOS integration of an IR filter and an IF filter is very difficult or impossible.

### Related art CMOS low noise amplifiers (LNAs)

The related art CMOS LNAs have various disadvantages. When the inductance for the related art CMOS LNAs is implemented by using an on-chip inductor such as a spiral inductor, the on-chip spiral inductor cannot guarantee required performance characteristics and cannot provide acceptable yields during mass-production fabrication. When the inductance for the related art CMOS LNAs is an off-chip inductor element, the off-chip inductors can cause a more complicated fabrication process, board layout and generates cost-increment in an overall system such as a CMOS RF communication system. Further, required connections to off-chip elements reduce performance characteristics.

### Related art CMOS voltage controlled oscillator (VCO) and mixer structure

As discussed above, a wide frequency range and a low phase noise are desirable for various applications. However, a CMOS VCO-mixer structure can only support up to a frequency 1 GHz with reliable phase noise and frequency range. The performance of the VCO-mixer structure becomes worse in terms of phase noise and frequency range and is unacceptable as the frequency of the clock signals LO + and LO- from the VCO increases. Hence, the VCO and the mixer cannot be readily implemented when the frequency $f_0$ of the clock signals LO + and LO- is over 1 GHz.

### Related art CMOS Automatic gain control loop

A related art direct conversion receiver requires DC offset cancellation. The related art approach for DC offset cancellation uses a high-pass filtering of the DC offset voltage incorporated within the gain stages. The integration of the high-pass filtering depends on the corner frequency and the amount of DC offset rejection. Since the spectrum of DC offset is restricted around zero frequency, and the high-pass filtering must not impair the desired signal, the desired corner frequency should be as low as possible. The capacitance C of the DC offset cancelling loop increases as a corner frequency $f_c$ decreases and an open loop forward gain $A_v$ increases. The capacitance C value typically reaches several hundred of nF, and it is difficult to integrate a capacitor of this value on a single chip. Thus, the capacitor is typically located at the outside of the chip. Unfortunately, when the off-chip capacitor is wired to the chip, a feedback connection is established, and some amount of noise is added via the bond wire coupling. This noise corrupts the signal integrity and degrades the signal-to-noise ratio (SNR).

### Related art CMOS phase locked loop (PLL)

Current VCO CMOS technology can support reliable operation only up to a frequency of approximately 1.0 GHz in terms of speed and noise. As the frequency $f_0$ of local oscillator clock signals LO + LO- increases over one GHz, a CMOS VCO cannot be implemented. To get the low phase noise sufficient for commercial applications such as PCS, however, an LC-resonant oscillator is used because of better phase noise performance than a CMOS ring-oscillator type VCO. A related art VCO has various disadvantages. For a CMOS single chip integration of an RF receiver or communications system, on-chip implementation of a spiral inductor has not been achieved with yields sufficient for mass-production manufacturing because the Q-factor of the integrated spiral inductor should be high enough for VCO oscillation. Manufacturing yield for the high Q-factor is difficult to achieve for the on-chip spiral inductor because of distributed lossy resistance of the substrate.

### Related art CMOS tuning ciruit

In related art approaches, either a high Q factor can result in poor matching between the master and the slave, or the input of gm-C integrator can comes from an external oscillator and the output comes from the OTA cell, which can produce inaccurate timing results.

### SUMMARY OF THE INVENTION

An object of the invention is to solve at least the above problems and/or disadvantages and to provide at least the advantages described hereinafter.

An object of the present invention is to provide a single chip CMOS transmitter/receiver and method that substantially obviates one or more problems and disadvantages of the related art.

A further object of the present invention is to fabricate a CMOS RF front end and method for using same that allows one chip integration of an RF communication system.

Another object of the present invention is to provide an RF communication system and method with reduced cost and power requirements.

Still another object of the present invention is to provide a reliable high speed, low noise CMOS RF communication system and method for using same.

Another object of the present invention is to increase a frequency range of a RF front end of an RF communication system.

Another object of the present invention is to provide a direct conversion RF communication system and method that provides a prescribed SNR regardless of an adjacent channel power level.

Another object of the present invention is to provide a baseband structure for a CMOS RF receiver on a single chip using selective two step amplification to meet desired gain for a selected RF channel and remove a larger adjacent channel.

In one aspect the present invention provides a direct conversion communication system, comprising: a receiver unit configured to receive RF signals including selected RF signals, wherein the selected RF signals have a predetermined carrier frequency; a demodulation-mixer configured to mix the selected RF signals with more than two multi-phase clock signals and output baseband signals; a first AGC amplifier configured to amplify the baseband signals until at least one of the baseband signals reaches a linearity limit; and a second AGC amplifier configured selectively to amplify a baseband signal output from the first AGC amplifier which lies within a desired channel to a desired dynamic range, and filter another one of the baseband signals output from the first AGC amplifier which does not lie within the desired channel.

In another aspect the present invention provides a method of operating a RF communication system, comprising: receiving RF signals including selected RF signals, wherein the selected RF signals have a predetermined carrier frequency; generating more than two multi-phase clock signals having a substantially identical frequency different from the predetermined carrier frequency; mixing the selected RF signals with the more than two multi-phase clock signals to output demodulated signals having a frequency reduced from the carrier frequency, wherein several of the more than two multi-phase clock signals are mixed to demodulate one of a first carrier frequency signal and a second carrier frequency signal; in a first AGC amplifier, amplifying the demodulated signals until at least one of the signals in a desired channel and an adjacent channel reach a linearity limit; and in a second AGC amplifier, amplifying the signal in the desired channel from the first AGC amplifier to a desired dynamic range, and filtering the signal in the adjacent channel from the first AGC amplifier.

Additional advantages, objects, and features of the invention will be set forth in part in the description which follows and in part will become apparent to those having ordinary skill in the art upon examination of the following or may be learned from practice of the invention. The objects and advantages of the invention may be realized and attained as particularly pointed out in the appended claims.

## BRIEF DESCRIPTION OF THE DRAWINGS

The invention will be described in detail with reference to the following drawings in which like reference numerals refer to like elements, and wherein:

Figure 1 is a circuit diagram showing a related art RF communication system;

Figures 2A-2E are diagrams showing signal propagation in the system of Figure 1;

Figures 3A and 3B are diagrams showing clock signal leakage in the system of Figure 1;

Figure 4 is a circuit diagram showing another related art RF communication system;

Figures 5A-5G are diagrams showing signal propagation in the system of Figure 4;

Figure 6 is a diagram showing a preferred embodiment of a multi-phase, reduced frequency (MPRF) RF communication system according to the present invention;

Figure 7 is a block diagram showing a receiver of a RF communication system according to a preferred embodiment of the present invention;

Figure 8 is a block diagram showing signal flow of the RF communication system of Figure 7; and

Figure 9 is a block diagram showing a receiver of a RF communication system according to another preferred embodiment of the present invention;

Figure 10 is a block diagram that illustrates a preferred embodiment of a CMOS LNA according to the present invention;

Figure 11 is a circuit diagram that illustrates a preferred embodiment of a CMOS LNA according to the present invention;

Figure 12A is a block diagram showing a VCO-mixer structure according to a preferred embodiment of the present invention;

Figure 12B is a circuit diagram showing a VCO-mixer structure of Figure 2A;

Figure 13 is a circuit diagram showing the VCO-mixer according to another preferred embodiment of the present invention;

Figures 14A-14H are operational timing diagrams showing a mixer of Figure 3;

Figure 15 is a circuit diagram showing yet another preferred embodiment of a mixer according to the present invention;

Figure 16 is a circuit diagram showing an exemplary quadrature down converter according to the third preferred embodiment;

Figure 17 is a circuit diagram showing still yet another preferred embodiment of a mixer according to the present invention;

Figure 18A is a block diagram of a DC offset cancelling circuit with a single feedback loop according to a preferred embodiment of the present invention;

Figure 18B is a schematic diagram of the DC offset cancelling circuit of Figure 18A;

Figure 19 is a diagram that illustrates impulse sensitivity function for a CMOS ring oscillator according to the related art;

Figure 20 is a diagram that illustrates a related art integer-N architecture; Figure 21 is a diagram that illustrates a related art fractional-N prescaler; Figure 22 is a diagram that illustrates a CMOS VCO according to a preferred embodiment;

Figure 23 is a diagram that illustrates a preferred embodiment of a fractional-N prescaler according to the present invention;

Figure 24 is a diagram that illustrates operational and timing waveforms according to a preferred embodiment of a fractional-N prescaler;

Figure 25 is a diagram that illustrates operational and timing waveforms according to a preferred embodiment of a fractional-N prescaler;

Figure 26 is a diagram that illustrates a preferred embodiment of a master-slave tuning circuit according to the present invention;

Figure 27 is a diagram that illustrates a preferred embodiment of a rectifier;

Figure 28 is a diagram that illustrates a preferred embodiment of a voltage-to-current converter; and

Figure 29 is a circuit diagram that illustrates an exemplary transconductance amplifier.

## DETAILED DESCRIPTION OF PREFERRED EMBODIMENTS

A single chip radio frequency (RF) communication system formed using CMOS techniques should satisfy the following operative requirements. A CMOS voltage controlled oscillator (VCO) has poor noise characteristics. Accordingly, a CMOS phase-locked loop (PLL) integration is required. However, the number of PLL should be small and the center frequency of a PLL preferably differs sufficiently from a transmitting RF frequency (e.g., is preferably low enough) to control a phase noise result using the CMOS VCO. High-quality filters are preferably eliminated because of associated disadvantageous area and power specifications in CMOS configurations. Also, a number of components in the CMOS RF system should be small or reduced without performance degradation.

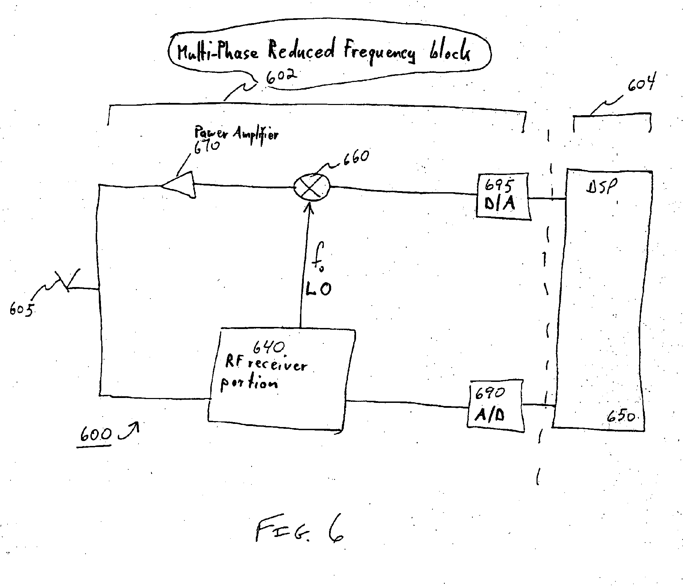

A first preferred embodiment of a "multi-phase reduced frequency" (MPRF) conversion RF communication system 600 is shown in Figure 6 and can preferably be formed on a single CMOS chip. The first preferred embodiment can operate at frequencies well above 1 GHz such as 1.8-2.4 GHz. The phrase "multi-phase reduced frequency conversion" is used because a single-phase periodic signal having a high frequency is preferably obtained by combining or multiplying multi-phase low-frequency periodic signals together. The first preferred embodiment of the MPRF conversion RF communication system 600 includes a front-end MPRF RF block 602 and a digital signal processing (DSP) block 604, which is preferably base-band. As discussed above, related art DSP blocks can be formed using CMOS techniques. Accordingly, a detailed explanation of the DSP block 604 including a digital signal processor 650 will be omitted.

The MPRF conversion RF block 602 includes an antenna 605, an RF receiver portion 640, analog/digital (A/D) converter 690, D/A converter 695, a power amplifier 670 coupled between a mixer 660 and the antenna 605. The receiver portion 640 generates a modulating and de-modulating clock, i.e., local oscillator (LO), whose frequency $f_0$ is determined by a reference clock.

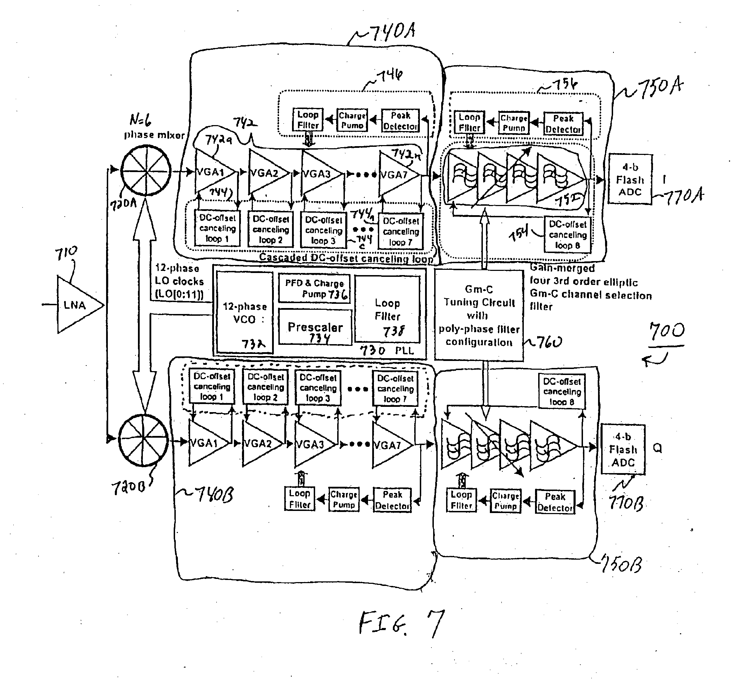

Figure 7 shows a block diagram of a first preferred embodiment of a receiver 700, which can operate as the receiver portion 640. As shown in Figure 7, the receiver 700 includes a full-CMOS low noise amplifier 710, a N-phase mixer 720A, 720B, a PLL generating multi-phase (e.g., 800 MHz) LO signals (e.g., LO[0:11]) 730, a variable gain amplifier (VGA) with a first automatic gain control (AGC) loop 740A, 740B, a gain-merged (e.g., four 3rd order Gm-C elliptic filter) filter with a second AGC loop 750A, 750B, a Gm-C tuning circuit with a poly-phase filter configuration 760. Each of an I-channel and a Q-channel signal is coupled to analog-to-digital converter (e.g., 4-bit flash ADC) 770A, 770B, respectively.

The PLL 730 preferably includes a N-phase voltage controlled oscillator (VCO) 732, a phase frequency detector (PFD) and charge pump 736, a loop filter 738 and a prescaler 734. The VCO 732 is preferably a multiple feedback loop VCO where each VCO cell of the VCO 732 preferably includes short rise/fall times and a large swing to obtain a phase noise reduced sufficiently for a wideband 2.4 GHz CDMA application. The prescaler 734 is preferably a multi-phase sampling fractional-N prescaler that performs fractional-N operations while preventing a fractional spur inside the channel bandwidth. Thus, the PLL 730 incorporates a bandwidth sufficient for a low phase noise 2.4 GHz W-CDMA without the fractional spur inside the channel bandwidth.

As shown in Figure 7, the PLL 730 generates 12-phase LO signals (LO[0:11]) for seven different channel frequencies. The N-phase mixer is preferably a quadrature down converter and as shown in Figure 7 includes two six-phase single-balanced mixers 720A, 720B where one is for the I-channel and the other is for the Q-channel. For example, as shown in Figure 7, the six-phase mixer 720A receives 800 MHz six-phase LO signals (LO[0, 2, 4, 6, 8, 10]) for the I-channel and the six-phase mixer 720B receives 800 MHz six-phase LO signals (LO[1, 3, 5, 7, 9, 11]) for the Q-channel. Accordingly, the 12-phase quadrature down converter 720 provides the function of a single-balanced mixer that receives a single-phase 2.4 GHz LO signal. In this example, the mixers 720A, 720B permit the CMOS VCO to provide multi-phase clock signals at a frequency $2f_0/N$ (e.g., one-third) of the carrier frequency $f_0$. Accordingly, a dominant power of the LO and its associated leakage is not at 2.4 GHz (the carrier frequency) because the VCO 732 is operating at 800 MHz. Thus, in the first preferred embodiment of the receiver 700, an amount of DC-offset can be drastically reduced due to the $2*f_0/N$ frequency of the VCO 732.

As shown in Figure 7, the mixers 720A, 720B output baseband RF signals. A baseband structure of the receiver 700 includes the first AGC loop 740A and the second AGC loop 750A. The AGC loop 740A includes n- VGA stages (e.g., n=7) 742a, 742b,..., 742n, a cascaded DC-offset canceling loop 744 having n-DC-offset canceling loops 744a, 744b, ..., 744n (e.g., n=7) and a first feedback loop 746. The second AGC loop 750A includes a gain-merged four 3rd order Gm-C elliptic filter 752, a DC-offset canceling loop 754 and a second feedback-loop 756. The first AGC loop preferably enables the desired channel to achieve the maximum gain before the channel selection filter in a case where there is a large adjacent channel condition. The second AGC loop preferably compensates gain lost for the desired channel because of the large adjacent channel blocker. The baseband structure first AGC loop 740B and the second AGC loop (with filter) 750B of the receiver 700 for the Q channel have a similar configuration to the I channel. Each of the feedback loops include a peak detector 746a, 756a, a charge pump 746b, 756b and a loop filter 746c, 756c.

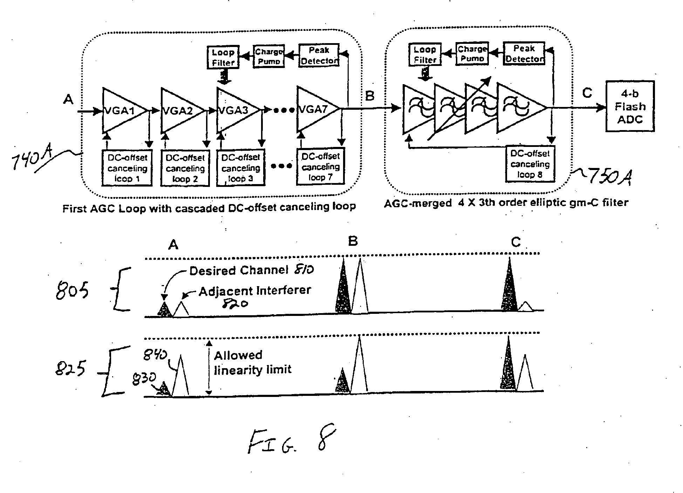

Figure 8 is a diagram that illustrates signal flow of the baseband structure of the receiver 700. As shown in Figure 8, two different conditions are illustrated. In a first condition, an input RF signal 805 is received from the mixer 720 where the adjacent channel power 820 is smaller than or equal to power of the desired channel 810. Preferably, according to the first preferred embodiment of the receiver 700, the desired channel obtains the required gain primarily from the first AGC loop 740. In a second condition, an input RF signal 825 is received from the mixer 720 where the adjacent channel power 840 is greater than (e.g., substantially larger) than the desired channel 830. When the RF signal 825 is received, the first AGC loop 740 amplifies the desired channel 830 until the adjacent channel power 840 reaches the allowed linearity limit. In the second AGC loop 750, the AGC loop is merged in a Gm-C channel selection filter that amplifies the desired channel to the desired level limited by the allowed linearity limit. By selectively controlling the conditions and operations of the first and second (e.g., cascaded) AGC loops 740, 750, an RF signal in the desired channel can still receive a maximum gain available to the RF signal 805 even when the RF signal 825 is received. Thus, the first preferred embodiment of the baseband structure of the receiver 700 obtains a gain provided by a dual-conversion receiver.

In addition, the output signal outputted from the last VGA of the VGA loop in the first AGC loop, is inputted back to VGA 3 as shown in Figure 8. However, the present invention is not intended to be so limited. For example, the output signal could also be looped back to a different one of the previous VGAs in the VGA loop such as VGA 1 or all the VGA stages.

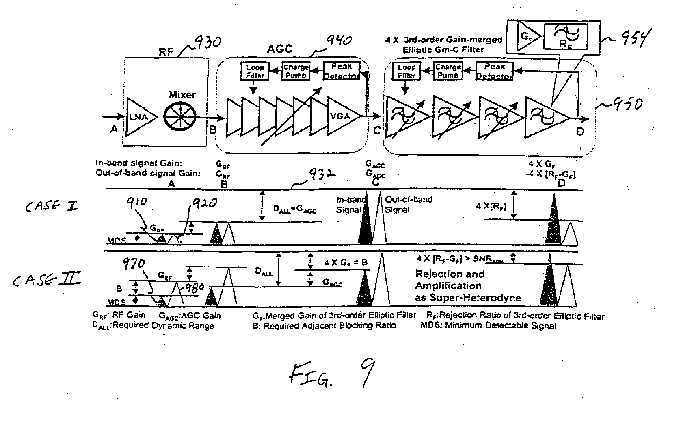

Figure 9 is a diagram that illustrates gain distribution of the receiver 700. As shown in Figure 9, case I illustrates the conditions where the amplitude of an adjacent channel blocker is equal (e.g., or less than) to the in-band signal. As shown in Figure 9, a received in-band signal 910 has a value being a minimum detectable signal (MDS). Similarly, an adjacent channel blocker 920 has an initial value being the MDS. As shown in case I of Figure 9, both of the in-band signal 910 and the out-of-band signal 920 receive a gain of $G_{RF}$ dB (decibels) by an RF stage 930. In a preferred embodiment, the RF stage 930 includes the LNA 710 and N-phase mixer 720. Thus, as shown at point B of case I in Figure 9, the in-band and out-of-band signals 910, 920 are signals having (MDS+$G_{RF}$) dB at an output terminal of the mixer 720. $G_{RF}$ is defined as an RF gain provided by an RF section 930.

The AGC 940 is a first stage AGC that amplifies both the in-band signal 910 and the out-of-band signal 920 until the dedicated linearity limit 932. In case I, the adjacent channel blocker (e.g., out-of-band signal 920) cannot prohibit the in-band signal 910 from receiving sufficient amplification. Thus, both the in-band and out-of-band signals 910, 920 are amplified up to (MDS+$G_{RF}$+$G_{AGC}$) dBm at an output terminal of the first AGC loop stage 940. $G_{AGC}$ is the AGC gain by the first AGC loop 940. Accordingly, in the second AGC loop 950 in case I shown in Figure 9, the in-band signal is preferably not amplified because a sufficient amplification was previously achieved to meet the dedicated signal level for the receiver 700. Preferably, the first AGC loop stage 940 achieves the amplification. However, in the second AGC loop 950, the adjacent channel blocker 920 is partially filtered to be reduced in amplitude As shown in Figure 9, in the second AGC loop 950, the adjacent channel blocker 920 is rejected preferably by a filter rejection ratio (e.g., 4 x $R_F$) in the filter stage without amplification because $G_F$ is set to 0 by the second AGC loop 950. $G_F$ is the merged gain of a 3rd order elliptic filter of the second AGC loop 950 and $R_F$ is the rejection ratio of 3rd order elliptic filter. In summary, in case I as shown in Figure 9, the gain of the VGA preferably included in the first AGC loop sufficiently covers the required dynamic range $G_{AGC}=D_{ALL}$. In the single chip CMOS RF receiver, $D_{ALL}$ is a required dynamic range to transfer the in-band signal. Thus, in case I of Figure 9, $G_{AGC}$ and equal $D_{ALL}$.

As shown in case II in Figure 9, the amplitude of the adjacent channel blocker 980 is larger than the in-band signal 970 by B dB, which is the required adjacent channel blocking ratio. As shown in case II of Figure 9, the MDS dBm of in-band signal 970 and the (MDS+B) dBm of the out-of-band signal 980 are applied to the RF stage 930. Accordingly, at an output terminal of the RF stage 930 (e.g., mixer output), the in-band signal 970 has a gain of (MDS+$G_{RF}$) dBm and the out-of-band signal 980 has a gain of (MDS+B+$G_{RF}$) dBm. In case II, the VGA of the first AGC loop 940 preferably amplifies both signals 970, 980 until the amplitude of the adj acent channel blocker 980 reaches the linearity limit 932. As a result, at the output of the first AGC loop 940 (e.g., VGA output terminal), the in-band signal 970 has a gain of (MDS+$G_{RF}$+$G_{AGC}$ dBm and the out-of-band signal 980 has a gain of MDS+$G_{RF}$+ $G_{AGC}$+B) dBm. Relative to the case I of Figure 9, the VGA gain $V_{AGC}$ (case II) is smaller than the VGA gain $V_{AGC}$ (case I) by B dB. In the second AGC loop 950 for case II of Figure 9, the gain-merged-filter stage 954 preferably amplifies the in-band signal 970 by (4 x $G_F$), which is preferably equal to the required blocking ratio, B dB. The out-of-band signal 980 is amplified by (4 x $G_F$) and simultaneously rejected by (4 x $R_F$) by the gain-merged-filter in the second AGC loop 950, which results in a total or net (4 x ($R_F$ - $G_F$)) rejection. Accordingly, in a second preferred embodiment of the receiver baseband structure shown in Figure 9, the required dynamic range is shared by the first AGC loop 940 (VGA) and the second AGC loop 950 (the gain-merged-filter) to provide the required dynamic range $D_{ALL}$ = $G_{AGC}$ + 4x$G_F$ = $G_{AGC}$ + B.

Although the second preferred embodiment of the baseband structure shown in Figure 9 indicates a first AGC loop followed by a second AGC loop 950, the present invention is not intended to be so limited. Thus, the second AGC loop 950 could be sequentially provided after a mixer of the RF section 930 prior to the first AGC loop 940. In such a case, the in-band RF signal would be first processed by preferably the Gm-C filter to block an adjacent channel prior to the gain from the first AGC loop 940 using preferably the VGA amplifiers.

As described above, the preferred embodiments of the CMOS receiver architecture and methods for using same have various advantages. In the preferred embodiments, a direct conversion receiver is provided having a SNR comparable to a super-heterodyne receiver. Further, in preferred embodiments of baseband structure and methods of using same according to the present invention a sufficient SNR is provided for an input signal regardless of an adjacent channel power level.

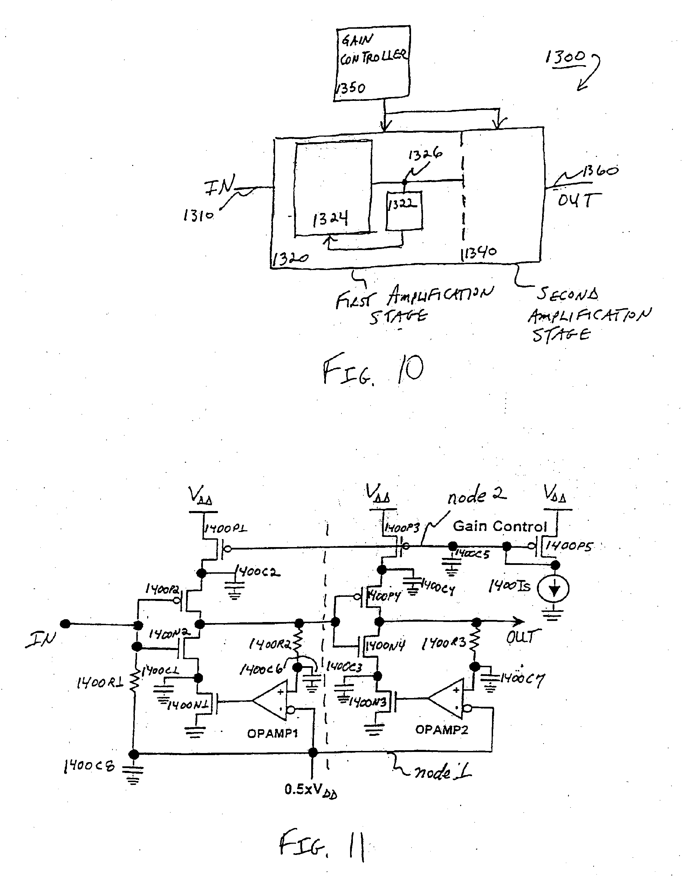

Figure 10 is a block diagram that illustrates a first preferred embodiment of a CMOS LNA according to the present invention, which preferably provides better linearity and gain controllability and is formed without inductors. The CMOS LNA 1300 includes an input terminal 1310 preferably coupled to received an RF signal input IN, a first amplification stage 1320 coupled to the input terminal 1310, a second amplifier stage 1340 coupled to an output node 1326 of the first amplification stage 1320 and an output terminal 1360 that preferably transmits an RF output signal OUT. Further, the CMOS LNA 1300 includes a gain controller 1350 coupled to the first and second amplification stages 1320, 1340.

The first preferred embodiment of the CMOS LNA is composed of two amplification stages, which can achieve the desired gain for the CMOS LNA 1300 adapted for use in a CMOS RF communications system. Each of the first and second amplification stages 1320, 1340 preferably has an identical configuration. However, the present invention is not intended to be so limited. The first amplification stage 1320 as shown in Figure 10 includes a feedback loop 1322 coupled between the output node 1326 and a first amplifier circuit 1324 of the first amplifier stage 1320. The feedback loop 1322 preferably establishes a DC bias point of the output node 1326 of the first amplification stage 1320.

The first amplification stage 1320 preferably includes a symmetric CMOS network to increase a dynamic range of the CMOS LNA 1300, in particular, under large RF signal inputs IN. Further, the gain of the CMOS LNA 1300 can be controlled by using the gain controller 1350. Preferably, the gain controller 1350 includes a current source I. The current level provided by the current source I of the gain controller 1350 is preferably copied on both of the first and second amplifier stages 1320, 1340. For example, the current level can be copied using a current mirror or the like.

Figure 11 is a circuit diagram that illustrates in more detail the first preferred embodiment of the CMOS LNA 1300 of Figure 10. The CMOS LNA 1300 can be a starved inverter type LNA. As shown in Figure 11, the first amplifier circuit 1324 includes four transistors 1400P1, 1400P2, 1400N2 and 1400N1 coupled in series between a power source voltage $V_{DD}$ and a ground voltage. The input terminal 1310 is coupled to gate electrodes of the transistors 1400P2 and 1400N2 whose drains are coupled in common to form the output terminal 1326 of the first amplification stage 1320. Further, a capacitor 1400C2 is coupled between the ground voltage and a junction coupling the transistors 1400P1 and 1400P2, and a capacitor 1400C1 is coupled between the ground voltage and a junction coupling the transistors 1400N2 and the transistors 1400N1.

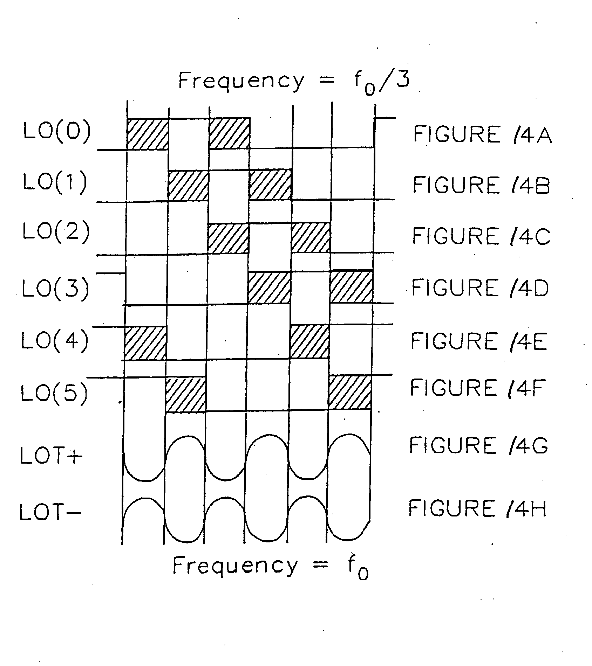

The second amplifier stage 1340 includes four transistors 1400P3, 1400P4, 1400N4,1400N3 coupled in series between the power source voltage $V_{DD}$ and the ground voltage. Further, gate electrodes of the transistors 1400P4 and 1400N4, each having drains commonly coupled to form an output node of the second amplification stage 1340, are coupled to the output node 1326 of the first amplification stage 1320. As shown in Figure 14, the output node of the second amplification stage 1340 is also the output terminal 1360. Further, capacitors 1400C4 and 1400C3 are coupled between the ground voltage and junctions coupling the transistors 1400P3 and 1400P4 and the transistors 1400N4 and 1400N3, respectively.

The feedback loop 1322 of the first amplification stage 1320 includes a resistor 1400R2, a capacitor 1400C6, an operational amplifier OPAMP1 and the transistor 1400N1. The resistor 1400R2 is coupled between the output node 1326 of the first amplifier circuit 1324 and a non-inverting input of the OPAMP1. The capacitor 1400C6 is coupled between the ground voltage and the non-inverting input of the OPAMP1. The output of the OPAMP1 is coupled to the gate electrode of the transistor 1400N1, and an inverting input of OPAMP1 is coupled to a voltage node 1.

As shown in Figure 11, a resistor 1400R1 and capacitor 1400C8 are coupled between the input terminal 1310 and the ground. The voltage node 1 is coupled to a junction between the resistor 1400R1 and the capacitor 1400C8. The feedback loop 1322 including the resistor 1400R2, the capacitor 1400C6, the OPAMP1 and the transistor 1400N1 establish the DC bias point of the output node 1326 of the first amplification stage 1320 and the input of the second amplification stage 1340, which is preferably adjusted to 0.5 $V_{DD}$ for coupling to the voltage node 1.

In a similar manner, a feedback loop of the second amplification stage 1340 includes a resistor 1400R3, a capacitor 1400C7, an operational amplifier OPAMP2 and the transistor 1400N3, which receives an output of the OPAMP2 at a gate electrode. Similar to the feedback loop 1322, the resistor 1400R3 is coupled between an output node of the second amplification stage 1340 and a non-inverting terminal of the OPAMP2. The capacitor 1400C7 is coupled between the ground voltage and the non-inverting terminal of the OPAMP2. An inverting terminal of the OPAMP2 is coupled to the voltage node 1.

Preferably, the transistors 1400P1-1400P4 are PMOS type transistors and the transistors 1400N1-1400N4 are NMOS type transistors. As can be appreciated, the preferred embodiment is not limited to such transistor type.

The gain controller 1350 includes transistor 1400P5 and current source 1400Is coupled in series between the power source voltage $V_{DD}$ and the ground voltage. Further, a gate electrode of the transistor 1400P5 is commonly coupled to a drain electrode connected to the current source 1400Is. In addition, the gate electrode of the transistor P5 is commonly coupled to a gate electrode of the transistor 1400P1, a gate electrode of the transistor 1400P3 and a capacitor 1400C5, which is also coupled to the ground voltage.

The 0.5 $V_{DD}$ bias and symmetric PMOS and NMOS networks of the first and second amplification stages 1320, 1340 enable symmetric operating points so that the PMOS and NMOS networks have an increased or maximum head-room and an increased or maximum dynamic range especially under a large RF signal input received at the input terminal 1310. The 0.5 $V_{DD}$ bias also enables transistors 1400N2,1400P2,1400N4 and 1400P4 to operate in a saturation region even when the large RF input signal is received.

The resultant gain of the first amplification stage can be determined from the transconductance of the transistor 1400P2 and the transistor 1400N2 (e.g., $gm_{400P2} + gm_{400N2}$) and a resultant output impedance of a parallel combination of the transistors 1400P2 and 1400N2 (e.g., $ro_{400P2} \| ro_{400N2}$), which is $GAIN_{1st} = (gm_{400P2} + gm_{400N2}) \times (ro_{400P2} \| ro_{400N2})$. In similar way, the gain of the second amplification stage is determined as $GAIN_{2nd} = (gm_{400N} + gm_{400N4}) \times (ro_{400P4} \| ro_{400N4})$. Should the first preferred embodiment of the CMOS LNA 1300 not have a symmetric structure, a full-down and full-up conditions would have different head-room and different characteristics, which would result in signal distortion depending upon the full-down and full-up conditions and decrease the linearity of such a CMOS LNA.

In addition, the gain of the first preferred embodiment of the CMOS LNA 1300 can be controlled by changing a value of the current source 1400Is. A current level from the current source 1400Is can be copied at each of the first and second amplifier stages 1320, 1340 preferably through a current mirror composed of the transistors 1400P5, 1400P3 and 1400P1. By increasing the value of the current source 1400Is, the transconductance of the transistors 1400P2, 1400N2, 1400P4 and 1400N4 increases, which results in an increment in gain. The capacitors 1400C6 and 1400C7 are preferably used to stabilize the two feedback loops of the first amplification stage 1320 and the second amplification stage 1340, respectively. The capacitors 1400C1-1400C5 and 1400C8 are preferably used to make AC-ground.

As described above, preferred embodiments of a CMOS LNA and methods of using same provide a desired gain for the wide frequency range, not at just a selected frequency. Further, if higher gain is required, a number of stages of the CMOS LNA can be increased. In addition, alternative embodiments of a gain controller can be used according to the present invention. For example, the gain can be controlled by putting and controlling load capacitance of each stage. Such a circuit for load capacitance control can be implemented by series connection of a pass-transistor and a capacitor, and the voltage of a gate electrode of the pass-transistor can be controlled to control an effective load capacitance.

As described above, preferred embodiments and methods for using same of a CMOS LNA according to the present invention have various advantages. The preferred embodiments according to the present invention provide a CMOS LNA that does not use an inductor. The preferred embodiments of the LNA can use a simplified manufacturing process. Further, the preferred embodiments of the CMOS LNA have symmetric amplification stages that allow symmetric pull-up and pull-down operations while achieving a desired gain. In addition, the preferred embodiments provide an increased linear performance.

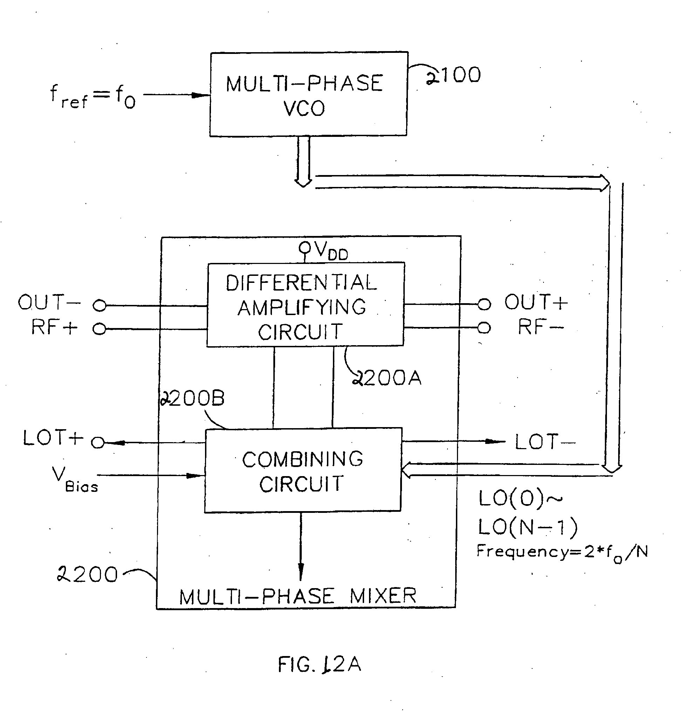

Figure 12A is a block diagram that illustrates a VCO-mixer structure in accordance with a first preferred embodiment of the present invention. The structure can be used for a RF communications system. The structure includes a multi-phase voltage controlled oscillator VCO 2100 and a multi-phase mixer 2200. The multi-phase mixer 2200 includes a differential amplifying circuit 2200A and a combining circuit 2200B.

When a reference clock signal having a reference frequency of $f_{REF}=f_0$ is used, the multi-phase VCO 2100 generates a plurality of N-phase clock signals LO(i=0 to N-1) having a frequency of $2*f_0N$, where $N=N_D*2$ and $N_D$-equals the number of delay cells in the multi-phase VCO 2100. In other words, the VCO 2100 reduces the frequency $f_0$ to $2*f_0N$. The frequency $2*f_0/N$ reduces the phase noise of the multi-phase VCO and increases the frequency range.

The plurality of N-phase intermediate clock signals LO(0), LO(1),....,LO(N-1) having a frequency of $2*f_0/N$ is inputted into the combining circuit 2200B of the multi-phase mixer 2200, and the input signals, for example, RF signals RF + and RF- are inputted into the differential amplifying circuit 2200A. The differential amplifying circuit 2200B differentially amplifies the radio frequency signals RF + and RF-. The combining circuit 2200B is responsive to a bias voltage $V_{Bias}$ and preferably combines the N-phase intermediate clock signals LO(0)-LO(N-1) to generate the output clock signals LOT+ and LOT-having the original frequency $f_0$. The mixer 2200 then accomplishes a multiplication of the output clock signals LOT+ and LOT- and the RF signals RF + and RF-.

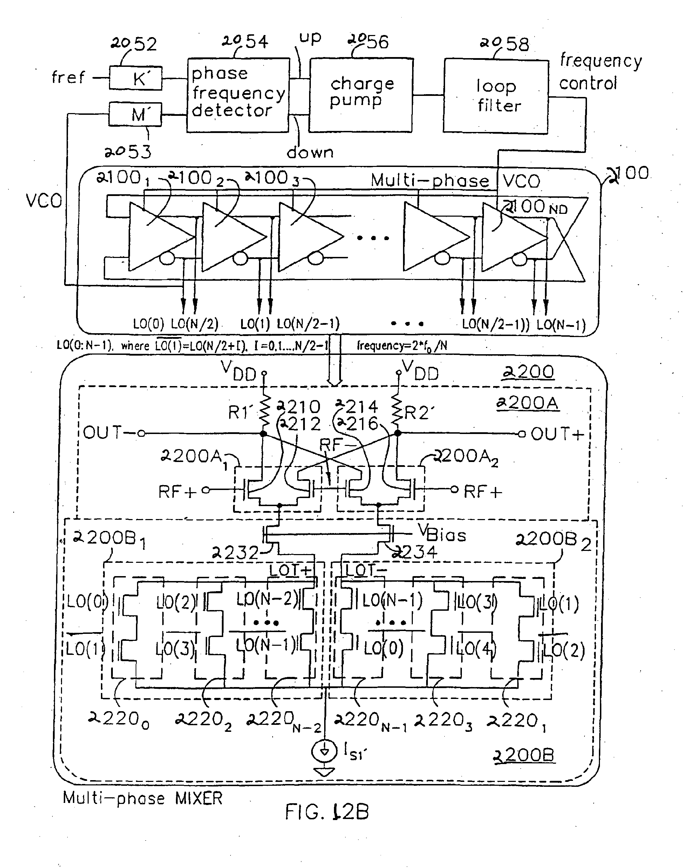

Figure 12B illustrates a circuit diagram of the VCO-mixer structure 2100, 2200 in accordance with a first preferred embodiment. The multi-phase VCO 2100 includes $N_D$ number of delay cells $2100_1$-$2100_{ND}$ coupled in series. Based on such configuration, the multi-phase VCO generates a plurality of N-phase intermediate clock signals LO(0)-LO(N-1) having a frequency of $2*f_0/N$. A control circuit for the VCO 2100 that generates a frequency control signal includes a phase frequency detector 2054, a charge pump 2056 and a loop filter 2058 that outputs the frequency control signal to each of the delay cells $2100_1$ - $2100_{ND}$. The phase frequency detector 2054 receives a reference clock signal $f_{ref}$ and a VCO clock signal $f_{VCO}$ from a reference clock divider circuit 2052 and a VCO clock divider circuit 2053, respectively. The frequency $2 f_0/N$ of the clock signals LO($\phi$) -LO(N-1) is represented by $M'/K'(f_{ref})=2f_0/N$. Thus, the frequency $f_0$ is based on the reference clock signal $f_{ref}$ and the divider circuits 2052 and 2053. In other words, $f_{VCO}$ can be $2f_0/N$ by setting $M'/K'$ of the divider circuits 2052 and 2053.

The differential amplifying circuit 2200A of the multi-phase mixer 2200 includes two load resistors R1' and R2' coupled to two differential amplifiers $2200A_1$ and $2200A_2$, respectively. The differential amplifier $2200A_1$ includes two NMOS transistors 2210 and 2212, and the differential amplifier $2200A_2$ includes two NMOS transistors 2214 and 2216. The drains of the NMOS transistor 2210 and 2216 are coupled to the load resistors R1' and R2', respectively, and the gates of the NMOS transistors 2210 and 2216 are coupled for receiving the RF signal RF+. Further, the drains of the NMOS transistors 2212 and 2214 are coupled to the load resistors R2' and R1', respectively, and the gates are coupled for receiving the RF signal RF-. The sources of NMOS transistors 2210 and 2212 and NMOS transistors 2214 and 2216 are coupled to each other and to the combining circuit 2200B of the multi-phase mixer.

The differential amplifiers $2200A_1$ and $2200A_2$ differentially amplifies the RF signals RF+ and RF-, respectively, such that a more accurate output signals OUT- and OUT + can be obtained. Further, the differential amplification removes noise that may have been added to the RF signals RF+ and RF-. As shown in Figure 12B, the mixer 2200 is a type of multi-phase double-balanced mixer. In this preferred embodiment, two differential amplifiers $2200A_1$ and $2200A_2$ are included, however, the present invention may be also accomplished using only one of the differential amplifiers in alternative embodiments.

The combining circuit 2200B includes bias NMOS transistors 2232 and 2234, first combining unit $2200B_1$ and second combining unit $2200B_2$ coupled to the bias NMOS transistors 2232 and 2234, respectively, and a current source $I_{s1}$, coupled to the first and second combining units $2200B_1$ and $2200B_2$. The first combining unit $2200B_1$ includes a plurality of transistor units $2220_0$, $2220_2$...$2220_{N-2}$, and the second combining unit includes a second plurality of transistor units $2220_1$,$2220_3$...$2220_{N-1}$.

Preferably, each of the plurality of transistor units includes a plurality of serially connected transistors, wherein the serially connected transistors are coupled in parallel with the serially connected transistors of the plurality of transistor units. Preferably, each transistor unit includes two (2) serially connected transistors. Hence, in the preferred embodiment, there are a total of N/2 number of transistor units in each combining unit 2200A or 2200B, such that the total number of NMOS transistors is 2*N.

The gate of the bias NMOS transistors 2232 and 2234 are coupled for receiving the bias voltage $V_{Bias}$, and the gates of the transistors in the first and second plurality of transistor units are coupled for receiving a corresponding N-phase intermediate clock signals LO(i) and /LO(i) having a frequency of $2*f_0/N$, where/LO(i) = LO(N/2+i), i = 0,1.., N/2-1. In this preferred embodiment, the bias NMOS transistors 2232 and 2234 are included for prevention of error, however, such transistors may be omitted in alternative embodiments. Further, the sequential ON-OFF operation of the 2*N number NMOS transistors of the combining circuit 2200B is equivalent to a NAND logic circuit, which can be interchanged with other equivalent logic circuits and structure in alternative embodiments.

The generic Figure 12B structure allows integration of the multi-phase VCO 2100 and multi-phase mixer 2200 on a single chip, i.e., on a single semiconductor substrate using CMOS technology. Such structure and layout reduce noise including noise caused by parasitic capacitances. As described above, the differential amplification using the RF signals RF+ and RF- in the differential amplifying circuit 2200A reduces noise.

The reduction of the reference frequency $f_0$ to N-phase intermediate clock signals LO(i) having a frequency of $2*f_0/N$ also reduces noise. When a plurality of transistors are formed on the same substrate, such as a semiconductor substrate for CMOS technology, a plurality of P-N junctions are formed in the substrate. The parasitic capacitances mostly exist at the P-N junctions. If the frequency of a signal applied to the gate of the transistor is very high, the higher frequency of $f_0$ causes much more noise compared to a reduced frequency of $2*f_0/N$.

Further, the operation of the differential amplifier circuit 2200A and the combining circuit 2200B is dependent on the output clock signals LOT+ and LOT- having a frequency of $f_0$, which are provided by the first combining unit $2200B_1$ and second combining unit $2200B_2$, respectively, by combining the N-phase intermediate clock signals LO(i) having a frequency of $2*f_0/N$. When the bias voltage $V_{Bias}$ is applied, the NMOS transistors 2232 and 2234 are turned ON and OFF based on the output clock signals LOT+ and LOT-. Although the NMOS transistors 2210, 2212, 2214 and 2216 are turned ON by the RF signals RF+ and RF- applied to the gate electrodes, the amplification of the RF signals RF+ and RF- and the output clock signals LOT+ and LOT- for generating the output signals OUT+ and OUT- is performed when the bias NMOS transistors 2232 and 2234 are turned on by the clock signals LOT+ and LOT-.

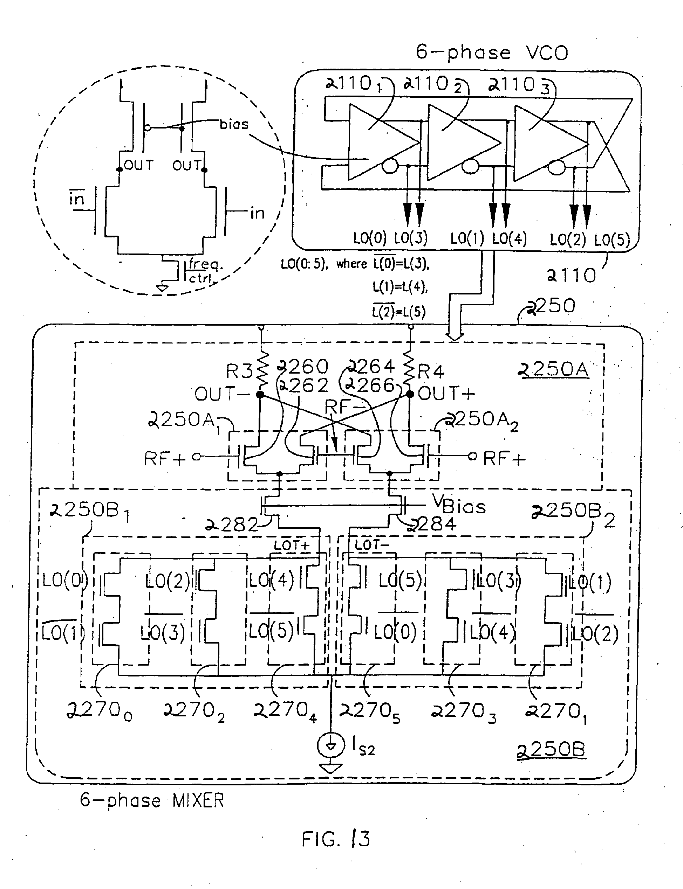

Figure 13 illustrates a second preferred embodiment of the multi-phase VCO and the multi-phase mixer when $N_D$=3 and N=6, and Figures 14A-14H illustrate the operational timing diagrams of the Figure 13 preferred embodiment. As shown, the multi-phase VCO 2110 includes three delay cells $2110_1$-$2110_3$ to generate 6-phase intermediate clock signals LO(0)-LO(5). An exemplary circuit including five transistors for the delay cells $2110_1$-$2110_3$ (i.e., the delay cell $2110_1$) is also shown. For illustrative purposes only, if the input clock signal has a frequency of $f_0$=1.5 GHz, the 6-phase intermediate clock signals LO(0)-LO(5) will have a frequency of 0.5 GHz.

The 6-phase mixer 2250 includes a differential amplifying circuit 2250A and a combining circuit 2250B. The differential amplifying circuit 2250A includes a first differential amplifier $2250A_1$ having NMOS transistors 2260 and 2262 and a second differential amplifier $2250A_2$ having NMOS transistors 2264 and 2266, which are coupled to load resistors R3 and R4, respectively. The combining circuit 2250B includes a first combining unit $22S0B_1$ and $2250B_2$, which are commonly coupled to a current source $I_{S2}$. The first and second combining units $2250B_1$ and $2250B_2$ are coupled to the first and second differential amplifiers $2250A_1$ and $2250A_2$ through bias NMOS transistors 2282 and 2284, respectively, which are biased by a bias voltage $V_{Bias}$. Cumulatively, the first and second combining units $2250B_1$ and $2250B_2$ includes six transistors units $2270_0$-$2270_5$ with a total of twelve transistors.

As shown in Figures 14A-14F, the 6-phase VCO 2110 generates 6-phase intermediate clock signals LO(1)-LO(5) having the reduced frequency $f_0/3$. The 6-phase mixer 2250 receives the 6-phase intermediate clock signals LO(1)-LO(5) and the RF signals RF+ and RF-. Each intermediate clock signal LO(1)-LO(5) and /LO(0)-/LO(2), where /LO(0) = LO(3), /LO(1) = L0(4) and /LO(2) = LO(5), is applied to a corresponding transistor of the first and second combining units $2250B_1$ and $2250B_2$. The first and second combining units $2250B_1$ and $2250B_2$ combine the 6-phase intermediate clock signals LO(0), LO(1),...LO(4), LO(5) having the frequency $f_0/3$ to generate the output clock signals LOT+ and LOT- having the frequency $f_0$.

As shown in Figures 14A-14H, when LO(0) is high and LO(1) is low (LO(4)=high), the two output signals LOT+ and LOT- are low and high, respectively. When LO(1) is high and LO(2) is low (LO(5)=high), the output signals LOT+, LOT- are high and low, respectively. When LO(2) is high and LO(3) is low (LO(0)=high), the output signals LOT+ and LOT- are low and high, respectively. When LO(3) is high and LO(4) is low (LO(1)=high), the output signals LOT+ and LOT- are high and low, respectively. When LO(4) is high and LO(5) is low (LO(2)=high), the output signals LOT+ and LOT- of the mixer 2503 are low and high, respectively. When LO(5) is high and LO(0) is low (LO(3)=high), the output signals LOT+ and LOT- are low and high, respectively.

Each pair of NMOS transistors in the combining circuit are turned on in order, thereby producing the output signals LOT + and LOT-, as shown in Figures 14G and 14H.

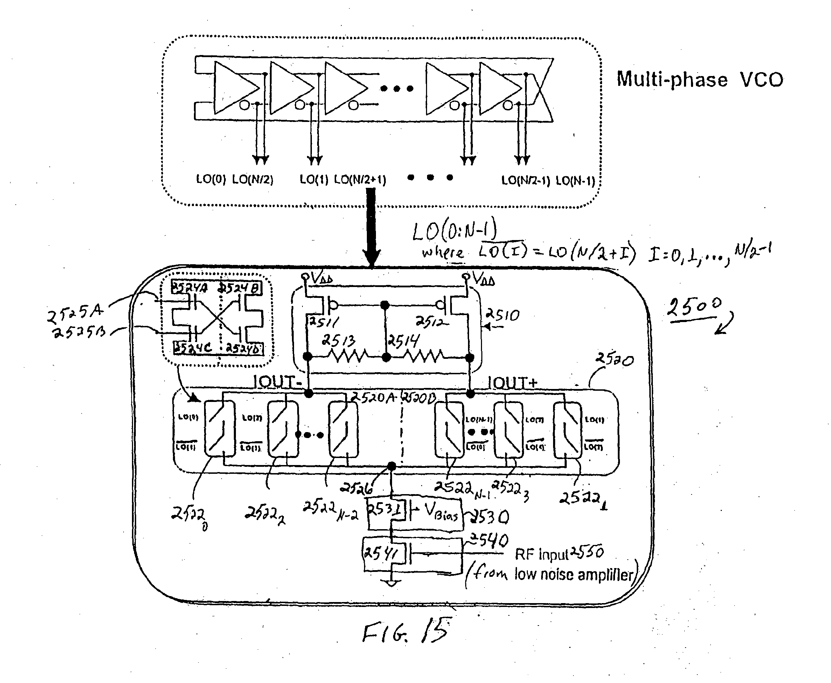

Figure 15 illustrates a third preferred embodiment of a multi-phase single balanced mixer according to the present invention. The third preferred embodiment of a multi-phase mixer 2500 is a type of single balanced mixer. The multi-phase mixer 2500 preferably receives N-phase, $2*f_0/N$ MHz LO clocks (LO (0:N-1)) and an RF signal and performs multiplication equivalent a single balanced mixer, which receives a single-phase $f_0$ MHz LO clock and the RF signal.

The multi-phase single balanced mixer 2500 preferably includes four functional blocks being a load block 2510, a switch array block 2520, a noise reduction block 2530 and an input block 2540. As shown in Figure 15, load block 2510 preferably includes two PMOS transistors 2511, 2512 and two load resistors 2513, 2514. The two PMOS transistors 2511, 2512 have source electrodes coupled to a source voltage $V_{DD}$ and gate electrodes commonly coupled together. The load resistors 2513, 2514 are respectively coupled between the gate electrodes and drain electrodes of the PMOS transistors 2511, 2512.

The PMOS transistors 2511, 2512 preferably are operating on a saturation region to provide high-impedance, and the resistors 2513, 2514 serve as a load resistance. The parallel combination of the resistor 2513 and the output impedance of PMOS transistor 2511 operates close to just the resistance of the resistor 2513 because the output impedance of transistor 2511 is large compared with the resistor 2513. Similarly, the parallel combination of the resistor 2514 and the output impedance of transistor 2512 is close to just the resistor 2516. The drain electrodes of the transistors 2511 and 2512 are respectively coupled to first and second switch networks 2520A and 2520B of a switch array block 2520 that perform multiplication of the multi-phase clock. A first switch network 2520A includes a plurality of transistor units $2522_0$, $2522_2$, ..., $2522_{N-2}$, and a second switch network 2520B includes a second plurality of transistor units $2522_1$, $2522_3$, ..., $2522_{N-1}$.

Preferably, the N-phase single-balanced mixer 2500 receives N-phase clock signals LO[0:N-1] and the RF signal. In a six-phase mixer, the LO signals would be LO[0:5]. As shown in Figures 14G-14H, the switch array block 2520 provides a mechanism to obtain the resultant effect equivalent to applying a single phase signal whose frequency is $F_0$ by using the N-phase LO signals whose frequency is $2*f_0/N$. The N-phase single-balanced mixer 2500 according to the third preferred embodiment includes N switches controlled by N-phase LO signals. One of the $\dfrac{N}{2}$ switches $2522_i$ in the first switch network 2520A and one of the $\dfrac{N}{2}$ switches $2522_i$ in the second switch network 2520B is alternately turned on at every phase interval as shown in Figures 14A-14F. As a result, virtual waveforms LOT+ and LOT- as shown in Figures 14G-14H are obtained by the multi-phase operation at output terminal IOUT- and IOUT+, respectively.

Preferably, each of the switches $2522_0$-$2522_{N-1}$ includes at least first and second pluralities of serially coupled transistors. Thus, as shown in Figure 15, each of the switches $2522_0$-$2522_N$ includes transistor 2524A coupled in series with transistor 2524C and transistor 2524B connected in series with transistor 2524D. Further, gate electrodes of the transistors 2524A and 2524D are commonly coupled to receive a corresponding multi-phase clock signal LO (e.g., LO(0)), and gate electrodes of the transistors 2524B and 2524C are commonly coupled to receive a corresponding multi-phase clock signal LO (e.g., LO(1)B). The transistors 2524A and 2524B further have source electrodes coupled to the load block 2510 at the output terminal IOUT-, and the transistors 2524C and 2524D have source electrodes coupled to a node 2526.

Preferably, each of the switches $2522_0$-$2522_{N-1}$ includes four NMOS transistors. Hence, in the third preferred embodiment, there are N/2 number of switches in each of the first and second switch networks 2520A or 2520B, such that the total number of NMOS transistors is 4*N. In addition, each of the switches $2522_0$-$2522_{N-1}$ includes symmetric NMOS transistors to provide an equivalent or symmetric electrical conditions to the two input ports 2525A, 2525B of each of the switches $2522_0$-$2522_{N-1}$.

A noise reduction block 2530 preferably includes a cascode NMOS transistor 2531 whose gate electrode is coupled to a bias voltage $V_{Bias}$. The noise reduction block operates to isolate the input block from the switch network 2520 to prohibit noise coupling to an input RF signal 2550. In the third preferred embodiment, the bias NMOS transistor 2531 is included to prevent error, however, such transistors enabled by the bias voltage $V_{Bias}$ can be omitted in alternative embodiments.

An input block 2540 includes NMOS transistor 2541 coupled to receive the RF input signal 2550 preferably from a low noise amplifier at a gate electrode. The transistor 2541 is coupled between the transistor 2531 and the ground voltage. The input voltage of the transistor 2540 is converted to a current level by the transconductance of the transistor 2541. The plurality of N-phase clock signals LO(0), LO(1),....,LO(N-1) having a frequency of $2*f_0/N$ is inputted into the switch array block 2520 of the multi-phase mixer 2500, and the RF input signal 2550 is inputted into the transistor 2541.

The load block 2510 can amplify the RF input signal 2500 when the switch array block 2520 preferably combines the N-phase clock signals LO(0)-LO(N-1) to generate the output clock signals LOT+ and LOT- having the original frequency $f_0$ responsive to the transistor 2531 receiving the bias voltage $V_{Bias}$ at the output terminals IOUT-, IOUT+. The mixer 2500 then accomplishes a multiplication of the output clock signals LOT+ and LOT- and the RF input signal 2550. As a result, the multi-phase single-balanced mixer 2500 can perform the operation equivalent to applying the high-frequency $f_0$ signal by using the reduced-frequency multi-phase LO clock signals.

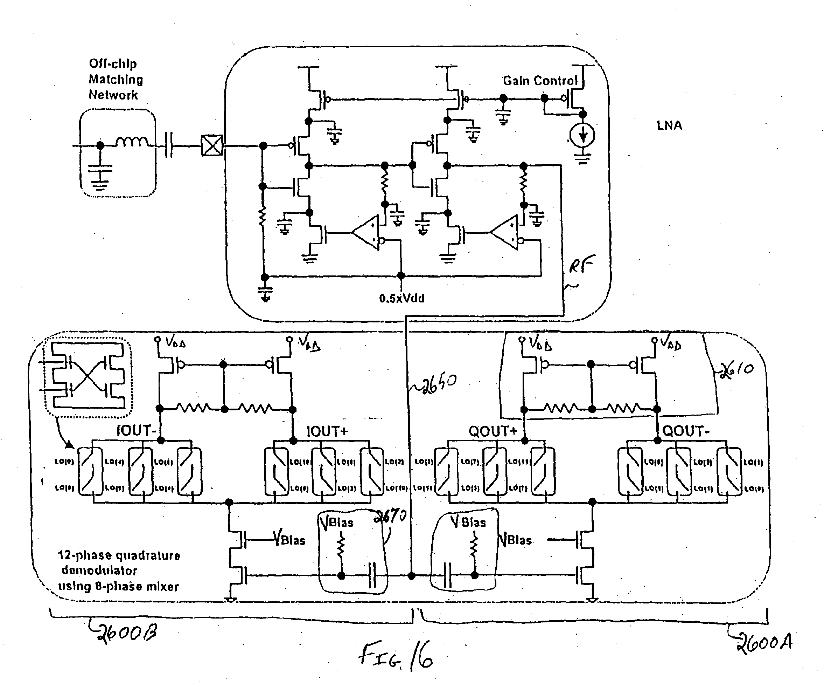

As an example, in an RF communication system, a 12-phase quadrature down converter as shown in Figure 16 can be composed of two six-phase single-balanced mixers 2600A, 2600B according to the third preferred embodiment. As shown in Figure 16, six-phase LO signals (LO[0, 2, 4, 6, 8, 10]) are used for an I-channel down conversion and the remaining six-phase LO signals (LO[1, 3, 5, 7, 9, 11]) are used for Q-channel down conversion. Each of the six-phase mixers in Figure 16 using six-phase LO signals having the frequency $f_0/3$ MHz perform the same functionality as a single-balanced mixer with the $f_0$ MHz single-phase LO signal. The third preferred embodiment of the mixer structure allows the use of a large amplitude LO[0:11] signals having reduced rise/fall times, and thus increases mixer conversion gains and decreases noise. To provide a more accurate output signal at the I and Q output terminals IOUT-, IOUT +, QOUT-, QOUT+, resistor and capacitor pairs 2670 can be added to an input path of an RF signal 2650. Further, a load block 2610 can be shared by the mixers 2600A, 2600B in alternative embodiments.

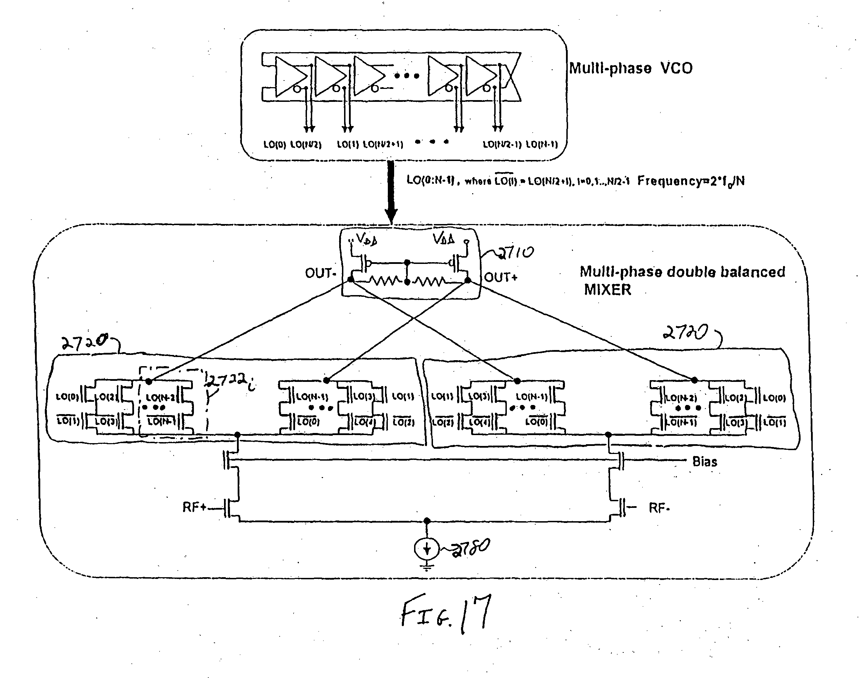

Alternatively, in a fourth preferred embodiment of a multi-phase mixer according to the present invention, two double-balanced mixers can be used to construct a quadrature down converter as shown in Figure 17. A double-balanced mixer 2700 receives a differential RF input RF+, RF- in contrast to the single-balanced mixers 2500, 2600 that can receive a single-ended RF input. As shown in Figure 17, the multi-phase double-balanced mixer 2700 incorporates a single load block 2710 commonly coupled to first and second switch arrays 2720. Each switch $2722_i$ uses a structure similar to the second preferred embodiment. In addition, a current source 2780 coupled between the differential RF input arid the ground voltage can be incorporated to improve performance characteristics.

As described above, preferred embodiments of a mixer and methods of using same have various advantages. The preferred embodiments allow robust and low noise VCO and mixer to be fabricated on a single substrate, preferably on a semiconductor substrate using CMOS technology. The preferred embodiments reduce interference caused by the input signal and the input clock signal because the frequency of the multi-phase intermediate clock signals deviate from the carrier signal frequency and the modulation frequency. A phase locked loop (PLL) frequency range can be increased because the PLL frequency range is based on the reduced frequency multi-phase clock signal frequency condition. Moreover, such results can enhance the channel selection capability of RF front-end in a RF communication system.

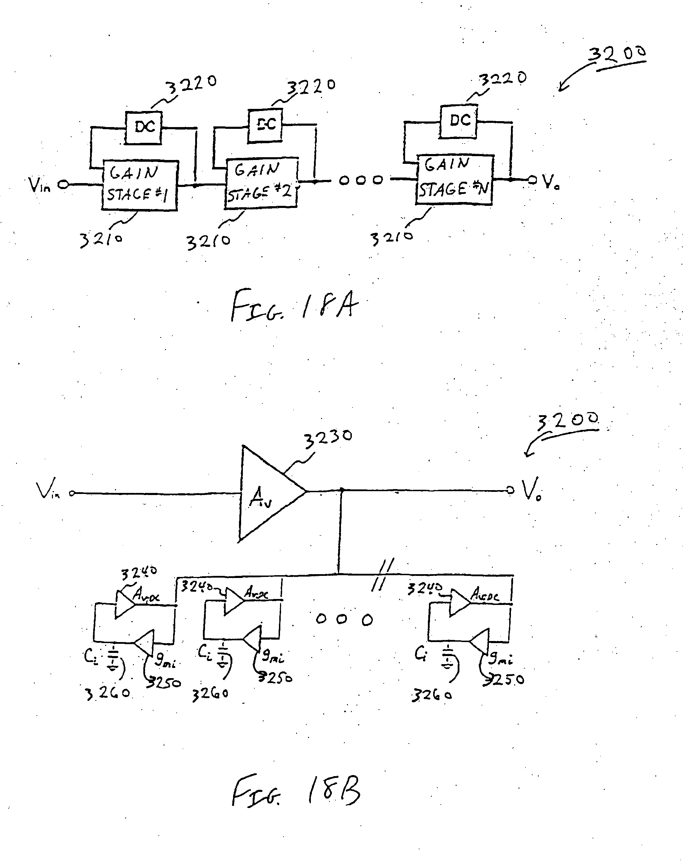

Figure 18a is a block level diagram of a DC offset cancelling circuit 3200 in accordance with a preferred embodiment of the present invention. Figure 18b is a schematic diagram of the DC offset cancelling circuit 3200 of Fig. 18a. As shown in Figs. 18a and 18b, the DC offset cancelling circuit 3200 includes a plurality of gain stages 3210 connected in series. However, instead of a single servo feedback loop, each gain stage 3210 has its own servo feedback loop and DC offset cancelling circuit 3220 to reject the DC offset of the respective gain stage 3210. In other preferred embodiments, each gain stage 3210 includes a variable gain amplifier (VGA) and each DC offset cancelling circuit 3220 includes a high pass filter.

An incoming signal having a voltage $V_{in}$ is amplified at each gain stage 3210. Each individual gain stage 3210 (*i*) has a gain of $A_{vi}$ and the total AGC loop gain is shown at equation 1 as:

$$A_v = \prod_i A_{vi} \qquad (1)$$

The transfer function for each gain stage 3210 is:

$$\frac{sA_{vi}}{s + \dfrac{g_{mi} A_{vi} A_{vi,DC}}{C_i}}$$

Since the gain stages 3210 are cascaded, the overall transfer function for the AGC loop 3200, having a number of gain stages 3210 (N), is shown at equation 2 as:

$$\frac{V_o}{V_{in}} = \left[ \frac{sA_{vi}}{s + \dfrac{g_{mi} A_{vi} A_{vi,DC}}{C_i}} \right]^N \qquad (2)$$

The cut-off frequency $f_{ci}$ of each gain stage is shown at equation 3 as:

$$f_{ci} = \frac{g_{mi} A_{vi} A_{vi,DC}}{2\pi C_i} \qquad (3)$$

and is preferably substantially equal for best overall performance. The total capacitance value of the AGC according to this preferred embodiment is the sum of the capacitance $C_i$ for each of the number of gain stages N. The ratio of total capacitance values indicates he capacitance value required for the DC offset cancellation circuit of the preferred embodiment. This ratio is shown at equation 4 as:

$$\frac{C_r}{\sum\limits_i C_{mi}} = \frac{A_{v,r}}{NA_{v,m}} \approx \frac{A_{v,m}^{N-1}}{N} \tag{4}$$

where $C_r$ represents the capacitance value for the related art DC offset cancelling circuit, and $C_m$ represents the capacitance value for the preferred embodiment of the present invention with multiple DC offset cancelling loops 3220. According to the above equation (4), the numerator grows exponentially, but the denominator grows linearly as the number N of gain stages 3210 increases. Thus, the total capacitance value decreases exponentially as the number N of gain stages 3210 increases. Therefore, the capacitance value of the preferred embodiment of the present invention is smaller than the capacitance value of the related art circuit, by several order of magnitudes for only a moderate number of gain stages.

Another advantage of the preferred embodiment of the present invention is that the amount of DC offset rejection is larger in the preferred embodiment, than in the related art single servo feedback approach. Based on equation (4), the DC offset decreases 20dB/decade for each gain stage 3220, in contrast with 20dB/decade for all the gain stages of the entire related art single feedback loop. In other words, the amount of DC offset is about N times greater in this preferred embodiment of the present invention than in the related art approach. This provides the benefit of substantially eliminating the trade-off between the cut-off frequency and amount of DC offset rejection. The large roll-off rate of the preferred embodiments of the present invention enable the sufficient suppression of DC offset even in the case of low cut-off frequency.

The method for analyzing phase noise of a CMOS ring oscillator can use equation 5 (Lesson's Equation) as follows:

$$PhaseNoise(\Delta\varpi) = 10 \cdot \left\{ \frac{2FkT}{P_{sig}} [1 + (\frac{\varpi_0}{2Q\Delta\varpi})^2] \cdot (1 + \frac{\Delta\varpi_{1/f}^3}{|\Delta\varpi|}) \right\} \tag{5}$$

According to equation 5, the phase noise ($\Delta\omega$) curve of phase noise plotted against frequency offset (log $\Delta\omega$) is composed of three different slope sections. At sufficiently small frequency offset from the carrier frequency ($f_0$), there is a first section that is proportional to $(1/\Delta\omega)^3$. The first section is generated by $1/f_0$ noise of the device. After the first section $(1/\Delta\omega)^3$, there is a second section having a curve that is proportional to $(1/\Delta\omega)^2$. Further, the phase noise spectra eventually flatten out for large frequency offsets in a third section, rather than continuing to drop as the square of the phase noise $\Delta\omega$. Such a noise floor may be due to the noise associated with any active elements (such as buffers) placed between VCO and the measuring equipments, or it can even reflect limitations in the measuring equipment itself. The factor F is empirical and varies significantly from oscillator to oscillator. The F value therefore must be determined from measurements. According to equation 1, increasing a Q-factor, increasing a signal amplitude or decreasing a center frequency are ways to reduce phase noise.

Another model for VCO phase noise analysis (Hajimiri) asserts that the phase displacement of an oscillator signal depends on when the impulse noise is applied. Thus, the phase noise analysis is time varying, and the shortcoming of the linear time-invariant noise analysis such as equation 5 (Lesson's equation) become apparent. To the extent that linearity remains a good assumption, the amount of phase displacement is proportional to magnitude of the noise impulse, and varies inversely with a total signal charge. Hence, the impulse response for the phase displacement may be shown at equation 6 as:

$$h\phi(t,\tau) = \frac{\Gamma(\varpi_0)}{q_{max}} u(t-\tau) \tag{6}$$

where $q_{max}$ is the maximum charge displacement for the signal, $u(t)$ is the unit step, a function $\Gamma(x)$ is the impulse sensitivity function (ISF), which is a dimensionless, frequency-and amplitude-independent function that is periodic in $2\pi$. The ISF encodes information about the sensitivity of the system to an impulse injected at phase $\omega_0\tau$. The ISF varies from oscillator to oscillator. Once the ISF has been determined (by standard methods), the excess phase can be determined through use of the superposition integral under the assumption of linearity as shown at equation (7) as:

$$\Phi(t) = \int_{-\infty}^{\infty} h\phi(t,\tau)i(\tau)d\tau = \frac{1}{q_{max}} \int_{-\infty}^{\infty} \Gamma(\varpi \circ \tau)i(\tau)d\tau \qquad (7)$$

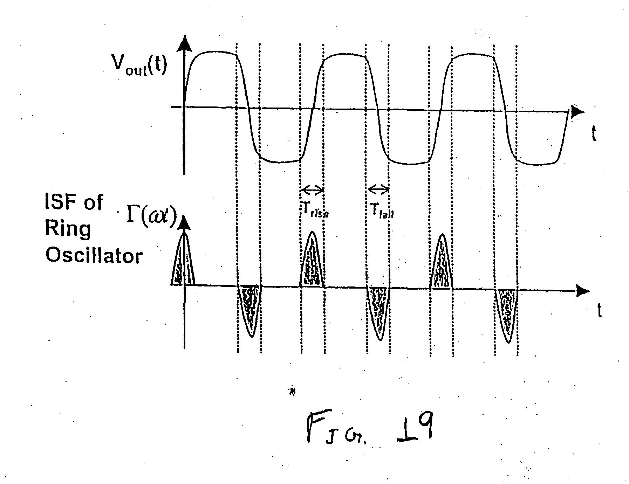

Fig. 19 is a diagram that shows the shape of ISF of a related art CMOS ring oscillator. As shown in Fig. 19, the absolute value of ISF function according to equation (3) has its maximum value during the transitions. In other words, noise impulse caused by device noise current affects the phase displacement on the transition region. Thus, to reduce or minimize the phase noise of CMOS ring oscillator, rise/fall time ($T_{rise}$, $T_{fall}$) should be reduced or minimized.

In addition, supply noise effects the phase noise of the CMOS VCO. The supply fluctuation can induce the abrupt phase displacement on CMOS ring oscillator, which results in the increment of phase noise. To reduce the supply noise effects on CMOS VCO, adding a source follower on the top of the VCO circuit is generally accepted as the solution for supply noise rejection. By using the source follower, the frequency of VCO can be controlled with the power supply noise effects reduced or minimized. The power supply is connected to a drain electrode of the source follower so that high impedance is seen from the power node. A source electrode of the source follower becomes an actual supply node of VCO, which is hardly affected by real power supply fluctuation.

To support commercial RF standards, such as PCS, WLL, and IMT2000, a prescaler should be added to the PLL to provide (a) large bandwidth to overcome large phase noise of CMOS ring oscillator and (b) relatively small channel spacing to meet the standards. However, supporting the large bandwidth and supporting the small channel spacing are trade-offs with each other (i.e., conflicting requirements) because both the PLL bandwidth and the channel spacing are proportional to the reference frequency applied to a phase detector. That is, relatively low VCO phase noise can be achieved for a large channel spacing.

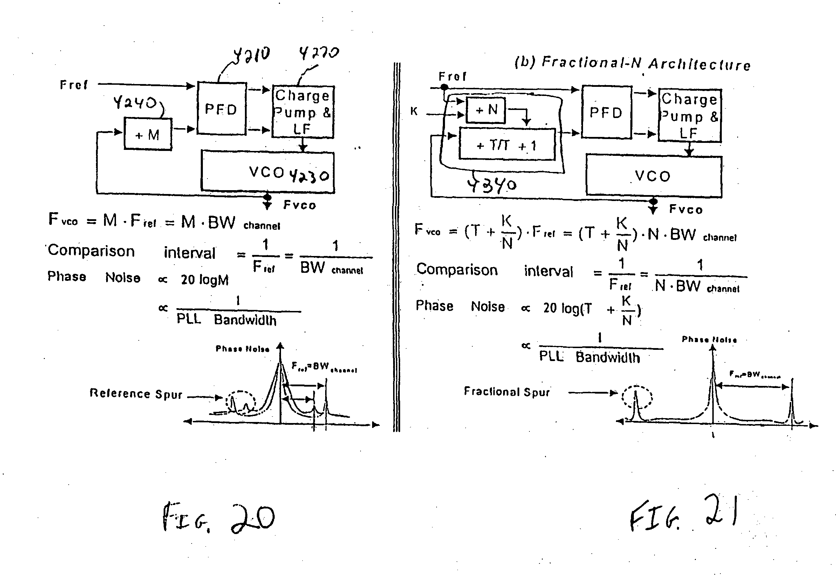

An integer-N prescaler and a fractional-N prescaler are two generally used related art prescaler architectures as shown in Figs. 20 and 21, respectively. As shown in Figure 20, a PLL architecture including the related art integer-N prescaler includes a phase frequency detector 4210, a charge pump and loop filter 4220 that outputs a frequency control signal to a VCO 4230. The phase frequency detector 4210 receives a reference clock signal Fref and a VCO clock signal Fvco from a VCO clock divider circuit 4240, respectively. The frequency $f_0$ of local oscillator clock signals from the VCO is represented by ($F_{ref}$)=$f_0$. Thus, the frequency Fvco is based on the reference clock signal Fref and the circuit 4240 in Fig. 20, and the frequency of the Fvco is determined by a reference clock frequency Fref.

For example, the related art integer-N architecture for PCS system as shown in Fig. 20, the reference frequency (Fref) applied to the phase detector should be the same as channel spacing (BWchannel), which is about 600KHz. Thus, the bandwidth of PLL using integer-N architecture is fixed to channel spacing, and the bandwidth sufficient to overcome large phase noise of CMOS ring oscillator is hard to get by using integer-N architecture. Another problem of the integer-N architecture is the *reference spur* problem. Whenever the phase detector 4210 compares the reference frequency Fref and the VCO 4230 frequency Fvco, the charge-pump 4220 provides charge for the loop filter, which corresponds to a phase error between the reference and VCO clock. The charge pumping mechanism whose frequency is equal to channel spacing induces a spurious spectral spur called the *reference spur,* which has a frequency equal to the channel spacing. The *reference spur* can cause severe problem on frequency conversion flow of an RF transmitter TX and an RF receiver RX because the spur frequency is located within the in-band region.

In the related art fractional-N architecture 4340 as shown in Fig. 21, the reference frequency (Fref) can be increased regardless of the channel spacing (BW$_{channel}$) so that sufficient bandwidth can be obtained to overcome the large phase noise of CMOS ring oscillator. As shown in Fig. 21, Fref is equal to N x BW$_{channel}$. By increasing N, the reference frequency Fref increases, which results in large bandwidth. However, the fractional spur problem exists in the related art fractional-N architecture 4340 because the fractional spur whose frequency is equal to the channel spacing can cause similar problem as that of reference spur in integer-N architecture. Further, the amount of the *fractional spur* is much larger than the amount of the *reference spur* of the related art integer-N architecture shown in Fig. 20. Accordingly, the related art PLL architecture adaptable for a CMOS RF communication system cannot overcome both of bandwidth and spur problems.

Preferred embodiments of a CMOS PLL adaptable for an RF communications system includes preferred embodiments of a multi-phased sampling fractional-N prescaler and VCO and methods of using same will now be described.

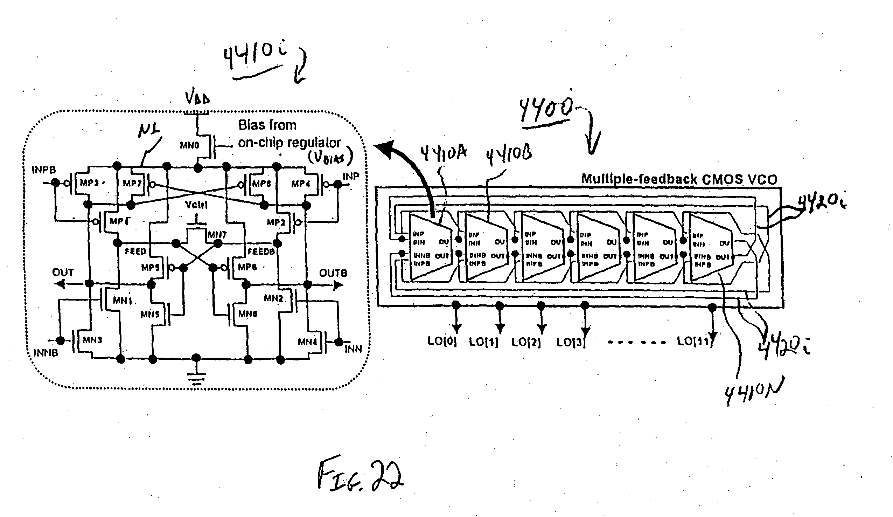

Figure 22 is a diagram that illustrates a preferred embodiment of a CMOS VCO according to the present invention. According to the preferred embodiment of a CMOS VCO, a multiple-feedback CMOS VCO 4400 includes multiple feedback loops 4420$_i$ for low phase noise. As shown in Figure 22, the CMOS VCO includes a plurality of serially coupled delay cells 4410A, 4410B,..., 4410N that output a plurality of N-phase clock signals LO[0:N-1]. The VCO 4400 has multiple feedback loops to increase the VCO frequency and reduce rise-fall times of the local oscillator LO waveforms. As shown in Figure 22, a VCO cell 4410$_i$ (i = 1-N) has four input ports (INP, INN, INNB, INPB) and two output ports (OUT, OUTB). The output terminal OUT (cell 4410$_i$) coupled to an input terminal INNB (cell 4410$_{i+1}$) and an input terminal INPB (cell 4410$_{i+2}$). An output signal OUT (cell 4410$_i$) and is coupled to an input terminal INN (cell 4410$_{i-1}$) and input terminal INP (cell 4410$_{i+2}$). However, output signals OUT, OUTB from cell 4410(N-1) are respectively fed back to input terminals INPB, INP of cell 4410(0), respectively and output signals OUT, OUTB from cell 4400(N) are fed back to input terminals of INNB, INN of cell 4400(0), respectively.

A preferred embodiment of a delay cell $4410_i$ of the VCO 4400 will now be described. As shown in Figure 22, each delay cell $4410_i$ includes four input terminals INP, INPB, INN, INNB, two output terminals OUT, OUTB and is coupled between a power source voltage $V_{DD}$ and a ground voltage and in addition receives a control voltage Vctrl. As shown in Figure 22, the cell $4410_i$ includes a first NMOS transistor MN0 coupled between the power supply voltage $V_{DD}$ and a first node N1. A gate electrode of the NMOS transistor MN0 receives a bias voltage $V_{BIAS}$ from preferably an on-chip regulator. Each cell $4410_i$ further includes pairs of transistors including MP3-MN3; MP1-MN1, MP5-MN5, MP6-MN6, MP2-MN2, and MP4-MN4 coupled between the first node N1 and the ground voltage. Further, the input terminal INP is coupled to a gate electrode of the transistors MP4 and MP2, an input terminal INN is coupled to gate electrodes of the transistors MN4, MN2, the input terminal INPB is coupled to gate electrodes of the transistors MP3, MP1 and the input terminal INNB is coupled to gate electrodes of the transistors MN3, MN1. The output terminal OUT of the cell $4400_i$ is coupled at a junction between drain electrodes of the transistor pair MP3-MN3 and drain electrodes of the transistor pair MP5-MN5. The output terminal OUTB is connected to the interconnection between drain electrodes of the transistor pair MP4-MN4 and drain electrodes of the transistor pair MP6-MN6. A transistor MN7 receives the control voltage Vctrl at a gate electrode, and is coupled between nodes FEED and FEEDB, respectively. Coupled drain electrodes of the transistor pair MP1-MN1 and gate electrodes of the transistor pair MP6-MN6 are also coupled to the node FEED. Coupled drain electrodes of the transistor pair MP2-MN2 and gate electrodes of the transistor pair MP5-MN5 are coupled to the node FEEDB. Further, a transistor MP7 has a source electrode coupled to the first node N1, a drain electrode coupled to the output terminal OUT and a gate electrode coupled to the output terminal OUTB. A transistor MP8 has a source electrode coupled to the first node N1, a drain electrode coupled to the output terminal OUTB and a gate electrode coupled to the output terminal OUT.

Operations of the cell $4410_i$ according to the preferred embodiment of the multiple-feedback CMOS VCO 4400 will now be described. In the cell $4410_i$, the transistor MN0 prevents noise injection caused by the supply fluctuation. Preferably, the transistor MN0 has a high impedance at the power supply voltage $V_{DD}$ side and a low impedance the first at node N1. Accordingly, effects of the supply fluctuation are reduced on the VCO operations. An inverter structure composed of the transistor pair MP3-MN3 and the transistor pair MP4-MN4 receive the signals INPB, INNB, INP, and INN, respectively, from a previous cell 4410(i -1) and generates the output signals OUT, OUTB at commonly coupled drain electrodes. The transistors MP7 and MP8 construct a positive feedback network or loop to supplement or improve the VCO 4400 oscillation and reduce rise/fall times. A second positive feedback network is preferably composed of four inverters, inverter1 (the transistor pair MP1-MN1), inverter2 (the transistor pair MP5-MN5), inverter3 (the transistor pair MP2-MN2) and inverter4 (the transistor pair MP6-MN6) to control the frequency of the VCO 4400 by changing a gate voltage Vctrl of the transistor MN7. When the control voltage Vctrl decreases, the output node FEED of the inverter1 and the output node FEEDB of the inverter3 become isolated. As a result, the signals at the output nodes FEED and FEEDB can operate in an inverted manner, which results in the inverter1 and the inverter3 providing positive feedback on the signal operation of the output terminal OUTB and the inverter2 and the inverter4 providing positive feedback on the signal operation of the output terminal OUT. In this case, the rise/fall time of the waveform on the output terminals OUT, OUTB is minimized but the VCO frequency becomes reduced because the strong positive feedback prohibits the VCO 4400 signal from quickly changing the state of the VCO 4400 signal. In other words, a time delay is generated for the VCO 4400 signal to change signal state and propagate. When the control voltage Vctrl increases, conductivity of the transistor MN7 increases to prevent the signals of the output nodes FEED and FEEDB from operating in the inverted manner. In other words, amplitude of the signals of the output nodes FEED and FEEDB are reduced by the increased conductivity of the transistor MN7. As a result, the positive feedback strength on the output terminal OUTB by the inverter1 and the inverter2 is reduced or weak, which results in a rapid state change of the VCO 4400 signal and an increment in the VCO 4400 frequency. In other words, the weak positive feedback helps the VCO 4400 signal to change its state quickly and with reduced resistance, which results in a frequency increment.

Accordingly, the preferred embodiment of the CMOS VCO 4400 in a PLL minimizes phase-noise of a CMOS ring oscillator by increasing an amplitude of the VCO signal, minimizing or reducing rise/fall time of the VCO signal and reducing or minimizing supply fluctuation noise effects on a VCO. As shown in Figure 22, transistors MNO-MN7 are preferably NMOS type transistors, and the transistors MP1-MP8 are preferably PMOS type transistors. However, the present invention is not intended to be so limited.

As described above, the preferred embodiments of the CMOS VCO and methods for operating same have various advantages. The preferred embodiments of the CMOS VCO have a symmetric PMOS/NMOS structure to match the rise/fall time of the local oscillator LO waveforms, which can reduce the phase noise caused by rise/fall time mismatch. Further, a frequency of the VCO according to the preferred embodiments can be controlled by adjusting the strength of the feedback network. The preferred embodiments use a simple control structure for the feedback networks. In particular, as a control signal value (e.g., Vctrl) decreases, the amount of feedback by the feedback networks increases. In the preferred embodiment of the VCO 4400, as Vctrl decreases, the voltage level of the output nodes FEED and FEEDB increase and the amount of feedback by the feedback network increases. Thus, a rapid or sharp rise/fall time for a VCO can be maintained by the preferred embodiments even at a reduced frequency. Thus, the preferred embodiments of the CMOS VCO and methods using the same provides a full swing LO signal with fast rise/fall time and high power supply rejection ratio (PSRR).

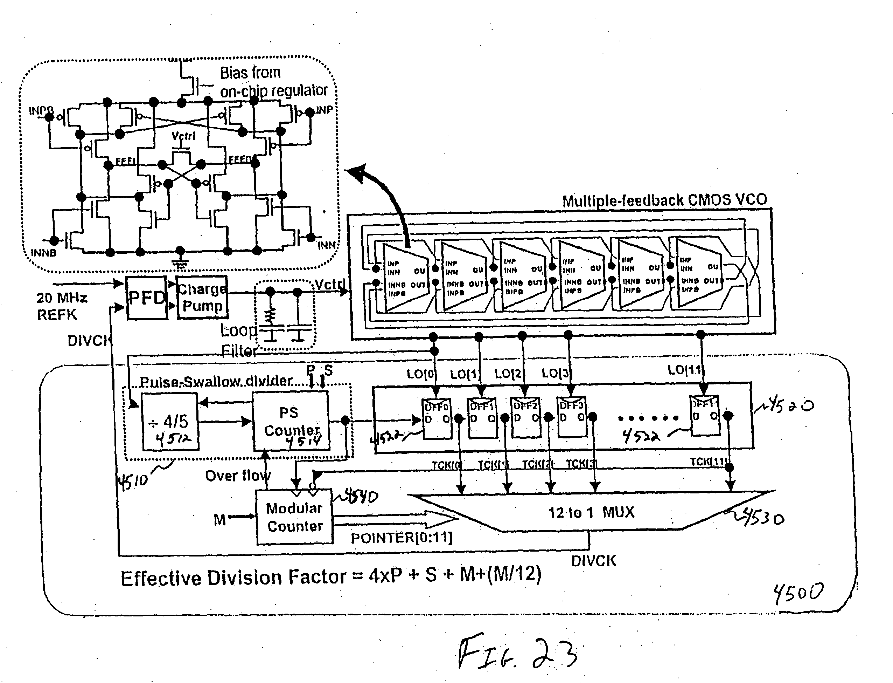

Figure 23 is a diagram that illustrates a phase lock loop according to a second preferred embodiment of the present invention. As shown in Figure 23, a second preferred embodiment of the PLL includes a CMOS VCO 4400 and a multi-phase sampling fractional-N prescaler 4500 includes a pulse-swallow divider 4510, a multi-stage (e.g., 12-stage) multi-phase sampler 4520, a multiplexer 4530 (e.g., 12 to 1 multiplexer) and a modular counter 4540.

The pulse-swallow divider 4510 preferably performs divide-by-[4xP+S] operations. The pulse-swallow divider 4510 includes a divider 4512 and a counter 4514. In the related art, the LO frequency is too high for robust logic operation such as selecting one phase signal among multi-phase signals using a selection operation such as a multiplexer operation. Thus, before selecting one phase signal among multi-phase clocks, division by the pulse-swallow divider 4510 is performed to decrease the frequency to provide more robust logic operations.

The output of the pulse-swallow divider 4510 is sampled by the multi-phase sampler 4520 that preferably includes a plurality of N flip flops 4522 coupled in series. As shown in Figure 23, the multi-phase sampler 4520 samples using 12-phase 800MHz LO clocks (LO[0:11]). The outputs of the 12-stage sampler 4520 (TCK[0:11]) have 12 different timings determined by the 12-phase LO clocks. A timing difference between the adjacent TCK clock signals are $(1 + 1/12) \times T_{VCO}$, where $T_{VCO}$ is the period of LO clocks coming from the VCO 4400. For example, as shown in Fig. 23, the number of multi-phase clock signals LO is 12, the frequency of LO clocks is 800MHz, $T_{VCO}$ is 1.25ns and the timing difference between the adjacent TCK clock is $(1 + 1/12) \times 1.25$ns. The reason that the timing difference is not $1/12 \times T_{VCO}$ but $(1+1/12) \times T_{VCO}$ is that the setup and hold time window of the 12-stage sampler 4520 is larger than $1/12 \times T_{VCO}$ and smaller than $(1 +1/12) \times T_{VCO}$. The modular counter 4520 periodically selects one of TCK[0:11] according to an input control signal M, which ranges from 0 to 11. The resultant period of the 12-to-1 multiplexer 4530 output DNCK is $[4x\ P+S+M+M/12] \times T_{VCO}$. Thus, the resultant division ratio of the first preferred embodiment of the prescaler 4500 is $[4x\ P+S+M+M/12]$.

As described above, the fractional spur of the related fractional-N prescaler is caused by clocking frequency of the prescaler, which is equal to the channel spacing. The preferred embodiment of the prescaler 4500 does not use a timing source whose frequency is equal to channel spacing. As a result, the prescaler 4500, with a fractional-12 operation (e.g., N=12), increases the PLL bandwidth and reduces the phase noise without the fractional spur. In particular, the fractional spur frequency of the prescaler 4500 is equal to the reference clock frequency (e.g., 800 MHz) and is far from the channel spacing. By changing the P, S, and M values, the PLL including the VCO 4400 and the prescaler 4500, can support different channel frequencies.

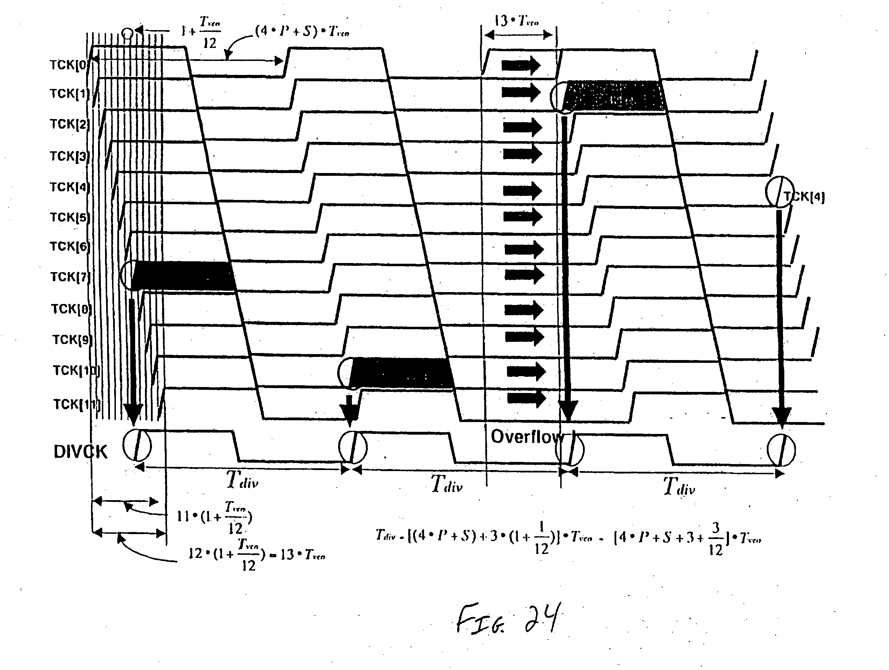

Operations of the preferred embodiment of the multi-phase sampling fractional-N prescaler 4500 will now be described. Fig. 24 is a diagram that shows operation and timing waveforms of the prescaler 4500 when M=3. The period of TCK[0:11] is $(4x\ P+S) \times T_{VCO}$. As shown in Fig. 24, TCK[7] is initially selected as the DIVCK. At this time, POINT[0:11] is 000000010000. After a first cycle, the modular counter 4530 shifts the POINT[0:11] value by 3, which results in POINT[0:11] is 000000000010. Thus, TCK[10] is selected as DIVCK for a second cycle. After the second cycle, POINT[0:11] becomes 010000000000. In a third cycle, TCK[1] is selected. However, in the third cycle shown in Fig. 24, a control signal OVERFLOW, which means that pointer value is smaller than that of the previous cycle (e.g., 1 < 10), is detected by the modular counter 4530. The modular counter 4530 asserts the OVERFLOW signal and controls the PS-Counter 4514 to increase its division factor by $13 \times T_{VCO}$ to maintain the exact timing as shown in Fig. 24. As a result, the period of DIVCK, which is applied as one phase detector PFD input, becomes $[4 \times P+S+3 \times (1+1/12)] \times T_{VCO}$ as shown in Figure 24. The other phase detector PFD input is a reference frequency, e.g., 20 MHz REFK. Thus, the effective division factor of the prescaler 4500 as shown in Figure 24 is $[4 \times P + S + 3 \times (1 + 1/12)]$.

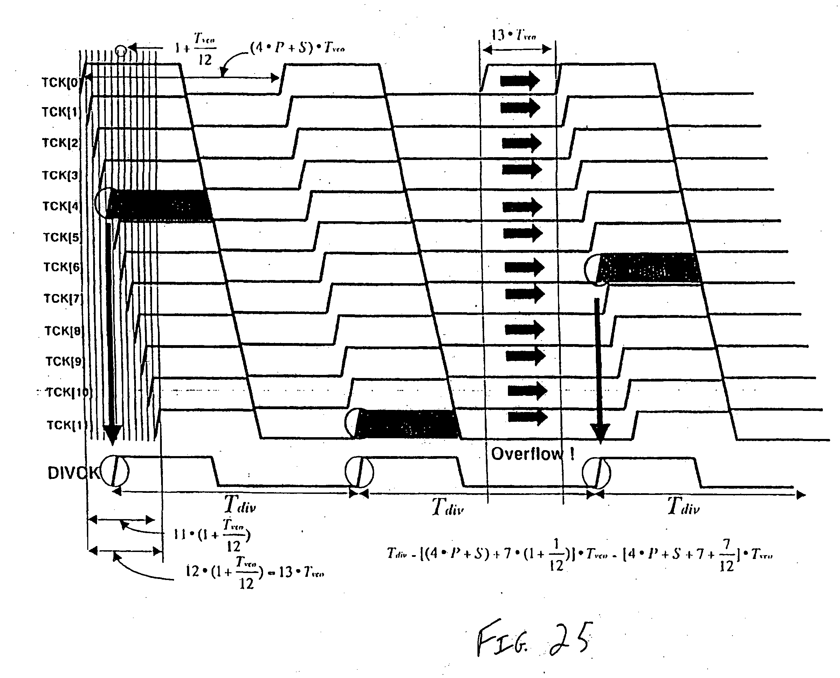

Fig. 25 is a diagram that shows operation and timing waveforms of the prescaler 4500 when M=7. The period of TCK[0:11] is $(4 \times P+S) \times T_{VCO}$. Initially, TCK[4] is selected as the DIVCK as shown in Fig. 25. At this time, POINT[0:11] is 000010000000. After a first cycle, the modular counter 4530 shifts the POINT[0:11] value by 7, which results in POINT[0:11] is 000000000001. Thus, TCK[11] is selected as the DIVCK. After a second cycle, POINT[0:11] becomes 000000100000. In a third cycle, TCK[6] is selected. But in the third cycle, the control signal OVERFLOW, which means that pointer value is smaller than that of the previous cycle (e.g., 6 < 11), is detected by the modular counter 4530. The modular counter 4530 applies the OVERFLOW signal and makes the PS-Counter 4514 increase its division factor by $13 \times T_{VCO}$ to maintain the exact timing as shown in Fig. 25. As a result, the period of DIVCK, which is applied as one of the phase detector PFD inputs, becomes $[4 \times P+S+7 \times (1 + 1/12)] \times T_{VCO}$. Thus, the effective division factor of the prescaler 4500 as shown in Figure 25 is $[4 \times P+S+7 \times (1+1/12)]$.

As described above, preferred embodiments of a prescaler 4500 have various advantages. The preferred embodiments of a PLL including a multi-phase fractional-N prescaler and methods of using same provide large bandwidth and spectral purity. Further, according to the preferred embodiments, the prescaler reduces or eliminates a fractional-spur problem. Accordingly, a PLL incorporating the preferred embodiments of the VCO and prescaler architecture and methods for using same increase performance characteristics for an RF CMOS single-chip communication system.

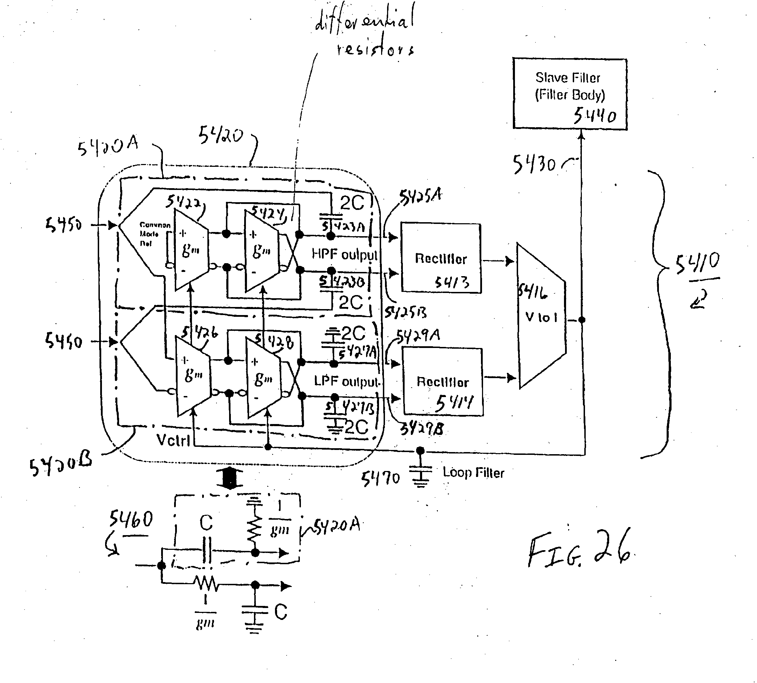

Figure 26 is a diagram that illustrates a preferred embodiment of a master-slave gm-C tuning circuit in accordance with the present invention. As shown in Figure 26, a master block 5410 copies a control voltage 5430 to a slave filter 5440. The master block includes a first rectifier 5413, a second rectifier 5414, a voltage-to-current (V-I) converter 5416 and a gm-C poly-phase filter 5420. As shown in Figure 26, the rectifier 5413 receives high pass filter output signals 5425A, 5425B from the filter 5420 and the rectifier 5414 receives low pass filter output signals 5429A, 5429B from the filter 5420. The V-I converter 5416 receives output from the rectifiers 5413, 5414 and outputs the control voltage 5430 to the slave filter 5440. The gm-C poly-phase filter 5420 includes transconductance amplifiers 5422, 5424, 5426, 5428. Positive and negative input ports of transconductance amplifier 5422 receive a common mode reference signal. A positive output port of transconductance amplifier 5424 is coupled to a negative output port of the transconductance amplifier 5422 and a negative input port of the transconductance amplifier 5424. A negative output port of the transconductance amplifier 5424 is coupled to a positive output port of the transconductance amplifier 5422 and a positive input port of the transconductance amplifier 5424. In addition, the positive and negative output ports of the transconductance amplifier 5424 are output nodes for the high pass filtered (HPF) output signals 5425B, 5425A, respectively. In addition, positive and negative input ports of the transconductance amplifier 5426 are coupled to receive a reference input signal 5450. A positive output port of a transconductance amplifier 5428 is coupled to the negative output port of the transconductance amplifier 5426 and a negative input port of the transconductance amplifier 5428. A negative output port of the transconductance amplifier 5428 is coupled to a positive output port of the transconductance amplifier 5426 and a positive input port of the transconductance amplifier 5428. The positive and negative output ports of the transconductance amplifier 5428 are output nodes for the low pass filtered (LPF) output signals 5429B, 5429A, respectively. Thus, the filter 5420 includes a high pass filter circuit 5420A and a low pass filter circuit 5420B. The reference signal 5450 is coupled to the positive and negative output ports of the transconductance amplifier 5424 through capacitors 5423B and 5423A, respectively. Capacitors 5427A and 5427B are coupled between a ground voltage and the negative and positive output terminals of the transconductance amplifier 5428. A diagram that illustrates an equivalent circuit 5460 of the gm-C poly-phase filter 5420 is shown in Figure 26.

In the preferred embodiment of the master-slave gm-C tuning circuit, the transconductance amplifiers 5426, 5428 receives the feedback loop control signal Vctrl as a control signal and respectively outputs the control signal Vctrl to the transconductance amplifiers 5422 and 5424. The sine wave is preferably used a reference signal. As shown in Figure 26, a 4 MHz sine wave is used as the reference signal to set the filter 5420 cut-off frequency.

During operations of the master block 5410, as the value of the Vctrl 5430 increases, transconductance values (gm) increase and the amplitude of the LPF output signals 5429A, 5429B increase and the amplitude of the HPF output signals 5425A, 5425B decrease. The rectifiers 5413, 5414 preferably detect peak levels of the HPF and LPF output signals respectively, for the comparison. The V-I converter 5416 receives the rectified outputs from the rectifiers 5413, 5414 and generates a pumping current that is preferably proportional to the difference of the amplitude of the rectified output. As a result, the amplitudes of the HPF output signals and LPF output signals are equalized by the negative feedback loop and results in a steady state transconductance value gm shown at equation 8 as follows:

$$\left| \frac{1}{1 + j\omega \dfrac{C}{g_m}} \right| = \left| \frac{j\omega \dfrac{C}{g_m}}{1 + j\omega \dfrac{C}{g_m}} \right| \quad \Leftrightarrow \quad g_m = \omega C = 2\pi f C \tag{8}$$

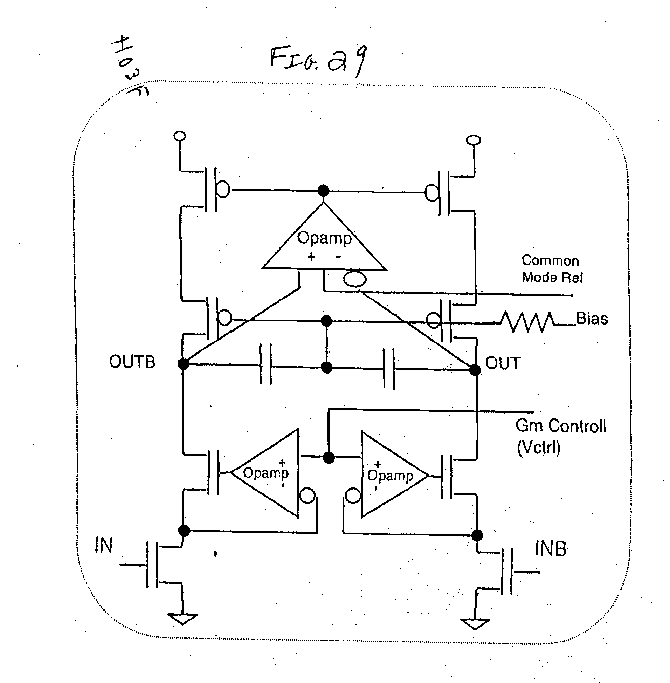

As described above, a master block such as the master block 5410 according to the preferred embodiments can be adapted as a tuning circuit for various types of transconductance amplifiers. An exemplary transconductance amplifier is illustrated in Figure 29. The transconductance amplifiers in the high pass filter section and the low pass filter section of the master block 5410 preferably provide a similar function of operating as resistor-equivalent whose value is 1/gm ohm. Further, the common mode reference signal is preferably a DC voltage whose value is about half $V_{DD}$ (e.g., 1/2 the supply voltage). In addition, in the master block 5410 a sine wave is the preferred reference signal 5450, however, alterative types of signals can be used such as a triangular wave can be applied. The frequency of the reference signal 5450 is preferably applied according to the required cut-off frequency of corresponding slave block. For example, if the cut-off frequency of slave filter is 6MHz, 4MHz sine wave should be replaced with 6MHz sine wave.

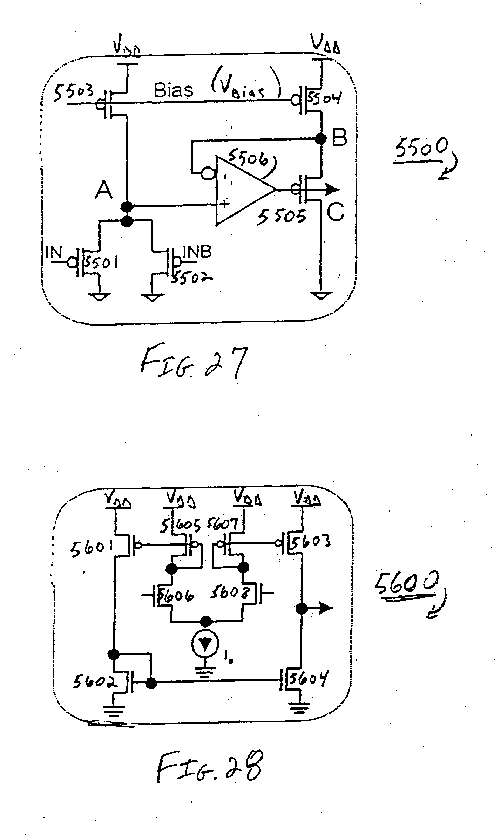

Figure 27 is a diagram that illustrates a preferred embodiment of a rectifier according to the present invention. As shown in Figure 27, a rectifier 5500 includes PMOS type transistors 5501, 5502 coupled in parallel between node A and a ground voltage. Gate electrodes of the PMOS transistors 5501 and 5502 respectively receive an input signal IN and an input signal complement INB. PMOS type transistor 5503 is coupled between a source voltage $V_{DD}$ and node A, and PMOS type transistor 5504 is coupled between the source voltage $V_{DD}$ and node B. Gate electrodes of the PMOS transistors 5503 and 5504 receive a bias voltage $V_{Bias}$. A fifth PMOS type transistor 5505 is coupled between node B and the ground voltage. An operational amplifier has an inverting terminal coupled to node B, a non-inverting terminal coupled to node A and an output coupled to the gate electrode of the PMOS type transistor 5505 to provide an output signal of the rectifier 5500. The rectifier 5500 can be used as the rectifier 5413, 5414 in Figure 26.

Figure 28 is a diagram that illustrates a preferred embodiment of a V-I converter 5600 according to the present invention. As shown in Figure 28, transistors 5601 and 5602 are coupled in series between a power source voltage $V_{DD}$ and the ground voltage. Further, transistors 5603 and 5604 are coupled in series between the source voltage $V_{DD}$ and the ground voltage by commonly coupled drain electrodes that provide an output signal of the V-I converter 5600. Transistors 5605 and 5606 are coupled in series between the source voltage $V_{DD}$ and a current source $I_S$, which is coupled to the ground voltage. Transistors 5607 and 5608 are coupled in series between the source voltage $V_{DD}$ and the current source $I_S$ by commonly coupled drain electrodes. In addition, gate electrodes and the drain electrode of the transistor 5605 are coupled together and to the gate of the transistor 5601. Similarly, a gate electrode and the drain electrode of the transistor 5607 are coupled together and to the gate electrode of the transistor 5603. Gate electrodes of the transistor 5606 and 5608 respectively receives input signals 5620 and 5622, respectively. The converter 5600 can be used as the V-I converter 5416 in Figure 26.

As described above, the preferred embodiment of the master-slave tuning circuits and methods of using same according to the present invention have various advantages. The control voltage of a feedback loop (e.g., Vctrl) is copied to a slave circuit and both the master and slave circuits use a gm-C filter. For an accurate amplitude comparison, electrical characteristics including for example common load level, loading capability should be matched. High-pass and lowpass filter portions of a poly-phase filter in the poly-phase filter according to the preferred embodiments use the same filter with different configurations. Further, output signals of the high and low pass filtering come from the same circuits so that both signals have the same electrical characteristics, which result in a more accurate tuning circuit relative to the related art tuning circuits. Further, the preferred embodiment of gm-C poly-phase filter tuning circuit provide a simpler circuit configuration for both the master and slave filter bodies. In addition, the preferred embodiments of a tuning circuit provide an increased robust operations relative to the VCO type related art tuning circuits due to elimination of disadvantages caused by the difficulty of oscillation and to high Q-factor requirements of the VCO type tuning circuits.

**Claims**

1. A direct conversion communication system, comprising:

   a receiver unit (640) configured to receive RF signals including selected RF signals (805, 825), wherein the selected RF signals (805, 825) have a predetermined carrier frequency;
   a demodulation-mixer (720A, 720B) configured to mix the selected RF signals (805, 825) with more than two multi-phase clock signals and output baseband signals; and
   a first AGC amplifier (740A, 740B; 740; 940) configured to amplify the baseband signals until at least one of the baseband signals reaches a linearity limit (932);
   **characterized by**:

   a second AGC amplifier (750A, 750B; 750; 950) configured selectively to amplify a baseband signal output from the first AGC amplifier (740A, 740B; 740; 940) which lies within a desired channel (810, 830; 910, 970) to a desired dynamic range, and filter another one of the baseband signals output from the first AGC amplifier (740A, 740B; 740; 940) which does not lie within the desired channel (810,830; 910, 970).

2. The communication system of claim 1, wherein the second AGC amplifier (750A, 750B; 750; 950) is configured to amplify the baseband signal within the desired channel (810, 830; 910, 970) to a prescribed amplitude which is greater than a required dynamic range of the communication system.

3. The communication system of claim 2, wherein an adjacent channel (820, 840; 920, 980) in the baseband signals has a greater power level than the baseband signal in the desired channel (810, 830; 910, 970) and the second AGC amplifier (750A, 750B; 750; 950) is a gain-merged filter.

4. The communication system of claim 1, further comprising:

   a RF filter coupled to the receiver unit (640) and configured to filter the selected RF signals (805,825) to output filtered RF signals;
a low noise amplifier (710) coupled to the RF filter and configured to amplify the filtered RF signals with a gain;
an A/D converting unit (690; 770A, 770B) configured to convert the baseband signals into digital signals; and
a digital signal processing unit (604) configured to receive the digital signals.

5. A method of operating a RF communication system, comprising:

receiving RF signals including selected RF signals (805, 825), wherein the selected RF signals (805, 825) have a predetermined carrier frequency;
generating more than two multi-phase clock signals having a substantially identical frequency different from the predetermined carrier frequency;
mixing the selected RF signals (805, 825) with the more than two multi-phase clock signals to output demodulated signals having a frequency reduced from the carrier frequency, wherein several of the more than two multi-phase clock signals are mixed to demodulate one of a first carrier frequency signal and a second carrier frequency signal; and
in a first AGC amplifier (740A, 740B; 740; 940), amplifying the demodulated signals until at least one of the signals in a desired channel (81.0, 830; 910, 970) and an adjacent channel (820, 840; 920, 980) reach a linearity limit (932);
**characterized by**:

in a second AGC amplifier (750A, 750B; 750; 950), amplifying the signal in the desired channel (810, 830; 910, 970) from the first AGC amplifier (740A, 740B; 740; 940) to a desired dynamic range, and filtering the signal in the adjacent channel (820, 840; 920, 980) from the first AGC amplifier (740A, 740B; 740; 940).

6. The method of claim 5, wherein the adjacent channel (840; 980) has a greater power level than the desired channel (830; 970) in the demodulated signals.

7. The method of claim 5, further comprising:

RF filtering the selected RF signals (805, 825) to produce filtered signals;
amplifying the filtered signals with a gain;
low pass filtering the demodulated signals having the frequency reduced to baseband;
A/D converting the low pass filtered signals into digital signals; and digitally processing the digital signals.

**Patentansprüche**

1. Direktumwandlungs-Kommunikationssystem, umfassend:

eine Empfängereinheit (640), die konfiguriert ist, RF-Signale einschließlich ausgewählter RF-Signale (805, 825) zu empfangen, wobei die ausgewählten RF-Signale (805, 825) eine vorbestimmte Trägerfrequenz aufweisen;
einen Demodulationsmischer (720A, 720B), der konfiguriert ist, die ausgewählten RF-Signale (805, 825) mit mehr als zwei Mehrphasen-Taktsignalen zu mischen und Basisbandsignale auszugeben; und
einen ersten AGC-Verstärker (740A, 740B; 740; 940), der konfiguriert ist, die Basisbandsignale zu verstärken, bis mindestens eines der Basisbandsignale eine Linearitätsgrenze (932) erreicht;
**gekennzeichnet durch**:

einen zweiten AGC-Verstärker (750A, 750B; 750; 950), der konfiguriert ist, selektiv ein Basisbandsignal, das von dem ersten AGC-Verstärker (740A, 740B; 740; 940) ausgegeben wird und in einem gewünschten Kanal (810, 830; 910, 970) liegt, in einen gewünschten Dynamikbereich zu verstärken, und ein anderes der Basisbandsignale, das von dem ersten AGC-Verstärker (740A, 740B; 740; 940) ausgegeben wird und das nicht innerhalb des gewünschten Kanals (810, 830; 910, 970) liegt, zu filtern.

2. Kommunikationssystem nach Anspruch 1, wobei der zweite AGC-Verstärker (750A, 750B; 750, 950) konfiguriert ist, das Basisbandsignal innerhalb des gewünschten Kanals (810, 830; 910, 970) auf eine vorgeschriebene Amplitude zu verstärken, die größer ist als ein erforderlicher Dynamikbereich des Kommunikationssystems.

3. Kommunikationssystem nach Anspruch 2, wobei ein benachbarter Kanal (820, 840; 920, 980) in den Basisbandsignalen ein höheres Leistungsniveau als das Basisbandsignal in dem gewünschten Kanal (810, 830; 910, 970) aufweist, und der zweite AGC-Verstärker (750A, 750B; 750; 950) ein Gain-Merged-Filter ist.

4. Kommunikationssystem nach Anspruch 1, weiter umfassend:

einen RF-Filter, der an die Empfängereinheit (640) gekoppelt ist und konfiguriert ist, die ausgewählten RF-Signale (805, 825) zu filtern, um gefilterte RF-Signale auszugeben;
einen Verstärker mit geringem Rauschen (710), der an den RF-Filter gekoppelt und konfiguriert ist, die gefilterten RF-Signale mit einem Anstieg zu verstärken;
eine A/D-Wandlereinheit (690; 770A, 770B), die konfiguriert ist, die Basisbandsignale in digitale Signale umzuwandeln; und
eine digitale Signalverarbeitungseinheit (604), die konfiguriert ist, die digitalen Signale zu empfangen.

5. Verfahren zum Betreiben eines RF-Kommunikationssystems, umfassend:

Empfangen von RF-Signalen einschließlich ausgewählter RF-Signale (805, 825), wobei die ausgewählten RF-Signale (805, 825) eine vorbestimmte Trägerfrequenz aufweisen;
Erzeugen von mehr als zwei Mehrphasen-Taktsignalen mit einer im Wesentlichen identischen Frequenz, die sich von der vorbestimmten Trägerfrequenz unterscheidet;
Mischen der ausgewählten RF-Signale (805, 825) mit den mehr als zwei Mehrphasen-Taktsignalen, um demodulierte Signale auszugeben, die eine in Bezug auf die Trägerfrequenz verringerte Frequenz aufweisen, wobei mehrere der mehr als zwei Mehrphasen-Taktsignale gemischt werden, um eines von einem ersten Trägerfrequenzsignal und einem zweiten Trägerfrequenzsignal zu demodulieren; und
Verstärken der demodulierten Signale in einem ersten AGC-Verstärker (740A, 740B; 740; 940) bis mindestens eines der Signale in einem gewünschten Kanal (810, 830; 910, 970) und einem benachbarten Kanal (820, 840; 920, 980) eine Linearitätsgrenze (932) erreicht;
**gekennzeichnet durch**:

Verstärken des Signals in den gewünschten Kanal (810, 830; 910, 970) aus dem ersten AGC-Verstärker (740A, 740B; 740; 940) in einem zweiten AGC-Verstärker (750A, 750B; 750; 950) bis zu einem gewünschten Dynamikbereich, und Filtern des Signals in dem benachbarten Kanal (820, 840; 920, 980) von dem ersten AGC-Verstärker (740A, 740B; 740; 940).

6. Verfahren nach Anspruch 5, wobei der benachbarte Kanal (840; 980) in den demodulierten Signalen ein höheres Leistungsniveau aufweist als der gewünschte Kanal (810, 830; 970)

7. Verfahren nach Anspruch 5, weiter umfassend:

RF-Filtern der ausgewählten RF-Signale (805, 825), um gefilterte Signale zu erzeugen;
Verstärken der gefilterten Signale mit einem Anstieg;
Tiefpassfiltern der demodulierten Signale, die eine Frequenz aufweisen, die auf das Basisband reduziert ist;
A/D-Wandeln der tiefpassgefilterten Signale in digitale Signale; und
digitales Verarbeiten der digitalen Signale.

## Revendications

1. Système de communication à conversion directe comprenant :

une unité réceptrice (640) configurée pour recevoir des signaux RF incluant des signaux RF sélectionnés (805, 825), dans lequel les signaux RF sélectionnés (805, 825) ont une fréquence porteuse prédéterminée ;
un mélangeur de démodulation (720A, 720B) configuré pour mélanger les signaux RF sélectionnés (805, 825) avec plus de deux signaux d'horloge multi-phases et délivrer en sortie des signaux en bande de base ; et
un premier amplificateur AGC (740A, 740B ; 740 ; 940) configuré pour amplifier les signaux en bande de base jusqu'à ce qu'au moins un des signaux en bande de base atteigne une limite de linéarité (932) ;
**caractérisé par** :

un deuxième amplificateur AGC (750A, 750B ; 750 ; 950) configuré de manière sélective pour amplifier un signal en bande de base délivré en sortie par le premier amplificateur AGC (740A, 740B ; 740 ; 940) qui se trouve à l'intérieur d'un canal désiré (810, 830 ; 910, 970) à une plage dynamique désirée, et filtrer un autre des signaux en bande de base délivrés en sortie par le premier amplificateur AGC (740A, 740B ; 740 ; 940) qui ne se trouve pas à l'intérieur du canal désiré (810, 830 ; 910, 970).

2. Système de communication selon la revendication 1, dans lequel le deuxième amplificateur AGC (750A, 750B ; 750 ; 950) est configuré pour amplifier le signal en bande de base à l'intérieur d'un canal désiré (810, 830 ; 910, 970) à une amplitude prescrite qui est supérieure à une plage dynamique nécessaire du système de communication.

3. Système de communication selon la revendication 2, dans lequel un canal adjacent (820, 840 ; 920, 980) dans les signaux en bande de base a un niveau de puissance plus élevé que le signal en bande de base dans le canal désiré (810, 830 ; 910, 970) et le deuxième amplificateur AGC (750A, 750B ; 750 ; 950) est un filtre à gain fusionné.

4. Système de communication selon la revendication 1, comprenant en outre :

un filtre RF couplé à l'unité réceptrice (640) et configuré pour filtrer les signaux RF sélectionnés (805, 825) pour délivrer en sortie des signaux RF filtrés ;
un amplificateur à faible bruit (710) couplé au filtre RF et configuré pour amplifier les signaux RF filtrés avec un gain ;
une unité de conversion analogique/numérique (690 ; 770A, 770B) configurée pour convertir les signaux en bande de base en signaux numériques ; et
une unité de traitement de signal numérique (604) configurée pour recevoir les signaux numériques.

5. Procédé de fonctionnement d'un système de communication RF, comprenant :

la réception de signaux RF incluant des signaux RF sélectionnés (805, 825), dans lequel les signaux RF sélectionnés (805, 825) ont une fréquence porteuse prédéterminée ;
la génération de plus de deux signaux d'horloge multi-phases ayant une fréquence sensiblement identique, différente de la fréquence porteuse prédéterminée ;
le mélange des signaux RF sélectionnés (805, 825) avec les plus de deux signaux d'horloge multi-phases pour délivrer en sortie des signaux démodulés ayant une fréquence réduite de la fréquence porteuse, dans lequel plusieurs des plus de deux signaux d'horloge multi-phases sont mélangés pour démoduler un parmi un premier signal de fréquence porteuse et un deuxième signal de fréquence porteuse ; et
dans un premier amplificateur AGC (740A, 740B ; 740 ; 940), l'amplification des signaux démodulés jusqu'à ce qu'au moins un des signaux dans un canal désiré (810, 830 ; 910, 970) et un canal adjacent (820, 840 ; 920, 980) atteignent une limite de linéarité (932) ;
**caractérisé par** :

dans un deuxième amplificateur AGC (750A, 750B ; 750 ; 950), l'amplification du signal dans le canal désiré (810, 830 ; 910, 970) provenant du premier amplificateur AGC (740A, 740B ; 740 ; 940) à une plage dynamique désirée, et le filtrage du signal dans le canal adjacent (820, 840 ; 920, 980) provenant du premier amplificateur AGC (740A, 740B ; 740 ; 940).

6. Procédé selon la revendication 5, dans lequel le canal adjacent (840 ; 980) a un niveau de puissance plus élevé que le canal désiré (830 ; 970) dans les signaux démodulés.

7. Procédé selon la revendication 5, comprenant en outre :

le filtrage RF des signaux RF sélectionnés (805, 825) pour produire des signaux filtrés ;
l'amplification des signaux filtrés avec un gain ;
le filtrage passe-bas des signaux démodulés ayant la fréquence réduite à la bande de base ;
la conversion analogique/numérique des signaux filtrés passe-bas en signaux numériques ; et
le traitement numérique des signaux numériques.

*100*

FIG. 1

BACKGROUND ART

FIG. 2

BACKGROUND ART

FIG. 3A

BACK GROUND ART

FIG. 3B

BACKGROUND ART

**FIG. 4**

**BACKGROUND ART**

**FIG. 5**

**BACKGROUND ART**

Multi-Phase Reduced Frequency block
602

604

Power Amplifier
670

660

695
D/A

DSP

$f_o$
LO

640
RF receiver
portion

605

690
A/D

650

600

FIG. 6

FIG. 7

First AGC Loop with cascaded DC-offset canceling loop

AGC-merged 4 X 3th order elliptic gm-C filter

FIG. 8

FIG. 9

FIG. 10

FIG. 11

FIG. 12A

Multi-phase MIXER

FIG. 12B

FIG. 13

Frequency = $f_0/3$

LO(0) — FIGURE /4A

LO(1) — FIGURE /4B

LO(2) — FIGURE /4C

LO(3) — FIGURE /4D

LO(4) — FIGURE /4E

LO(5) — FIGURE /4F

LOT+ — FIGURE /4G

LOT− — FIGURE /4H

Frequency = $f_0$

FIG. 15

FIG. 16

Multi-phase VCO

LO(0) LO(N/2)   LO(1) LO(N/2+1)  • • •   LO(N/2-1) LO(N-1)

$\overline{LO(0:N-1)}$, where $\overline{LO(I)}$ = LO(N/2+I), I=0,1...N/2-1  Frequency=2*f$_o$/N

Multi-phase double balanced
MIXER

Bias

RF+        RF-

FIG. 17

EP 1 228 564 B1

FIG. 18A

FIG. 18B

$V_{out}(t)$

$T_{rise}$   $T_{fall}$

ISF of
Ring
Oscillator   $\Gamma(\omega t)$

FIG. 19

(b) Fractional-N Architecture

$F_{vco} = M \cdot F_{ref} = M \cdot BW_{channel}$

Comparison interval $= \dfrac{1}{F_{ref}} = \dfrac{1}{BW_{channel}}$

Phase Noise $\propto 20 \log M$

$\propto \dfrac{1}{PLL \ Bandwidth}$

$F_{vco} = (T + \dfrac{K}{N}) \cdot F_{ref} = (T + \dfrac{K}{N}) \cdot N \cdot BW_{channel}$

Comparison interval $= \dfrac{1}{F_{ref}} = \dfrac{1}{N \cdot BW_{channel}}$

Phase Noise $\propto 20 \log(T + \dfrac{K}{N})$

$\propto \dfrac{1}{PLL \ Bandwidth}$

Reference Spur

Fractional Spur

FIG. 20

FIG. 21

FIG. 22

Bias from on-chip regulator

Multiple-feedback CMOS VCO

20 MHz REFK

PFD | Charge Pump

Loop Filter

Vctrl

DIVCK

Pulse-Swallow divider

P S

LO[0]  LO[1]  LO[2]  LO[3]  LO[11]

÷ 4/5
4512

PS Counter
4514

DFF0  DFF1  DFF2  DFF3  DFF11

4522

4520

4522

4510

Over flow

TCK[0]  TCK[1]  TCK[2]  TCK[3]  TCK[11]

M →  Modular Counter

4540

12 to 1 MUX

4530

POINTER[0:11]

DIVCK

Effective Division Factor = 4xP + S + M+(M/12)

4500

FIG. 23

EP 1 228 564 B1

FIG. 24

Fig. 25

FIG. 26

FIG. 27

FIG. 28

FIG. 29

**REFERENCES CITED IN THE DESCRIPTION**

**Patent documents cited in the description**

- US 5963855 A